(19) **Europäisches Patentamt**

**European Patent Office**

**Office européen des brevets**

(11) **EP 1 087 533 A1**

(12) **EUROPEAN PATENT APPLICATION**
published in accordance with Art. 158(3) EPC

(43) Date of publication:
28.03.2001 Bulletin 2001/13

(51) Int. Cl.$^7$: **H03M 7/30**, H04N 1/41, H04N 7/28

(21) Application number: 99913695.5

(22) Date of filing: 19.04.1999

(86) International application number:
PCT/JP99/02050

(87) International publication number:
WO 99/55007 (28.10.1999 Gazette 1999/43)

(84) Designated Contracting States:
DE FR GB NL SE

(30) Priority: 17.04.1998 JP 12428398
03.07.1998 JP 18951698
23.07.1998 JP 20836598
30.10.1998 JP 30980898

(71) Applicants:
• **Ohmi, Tadahiro**
Sendai-shi, Miyagi-ken 980-0813 (JP)
• **Ultraclean Technology Research Institute, Co. Ltd**
Tokyo 113-0033 (JP)

(72) Inventors:
• **OHMI, Tadahiro**
Miyagi 980-0813 (JP)
• **KOTANI, Koji**
Chiba 261-0005 (JP)
• **NAKADA, Akira**
Tokyo 121-0055 (JP)

• **IMAI, Makoto**
Sendai-shi Migayi 980-8579 (JP)
• **KONDA, Masahiro**
Aoba-ku, Sendai-shi Miyagi 980-8579 (JP)
• **MORIMOTO, Tatsuo**
Aoba-ku, Sendai-shi Miyagi 980-8579 (JP)
• **YONEZAWA, Takemi**
Aoba-ku, Sendai-shi Miyagi 980-8579 (JP)
• **NOZAWA, Toshiyuki**
Aoba-ku, Sendai-shi Miyagi 980-8579 (JP)
• **NAKAYAMA, Takahiro**
Aoba-ku, Sendai-shi Miyagi 980-8579 (JP)
• **FUJIBAYASHI, Masanori**
Aoba-ku, Sendai-shi Miyagi 980-8579 (JP)
• **NITTA, Takahisa,**
Bunkyo-ku Tokyo 113-0033 (JP)

(74) Representative:
**VOSSIUS & PARTNER**
Siebertstrasse 4
81675 München (DE)

(54) **METHOD AND APPARATUS FOR MAKING CODE BOOK, VECTOR QUANTIZING DEVICE, DEVICE AND METHOD FOR DATA COMPRESSION, DEVICE AND METHOD FOR DATA DECOMPRESSION, SYSTEM FOR DATA COMPRESSION/DECOMPRESSION**

(57) With reference to one or more pieces of data (for example, the data at the left end in a block of $4 \times 4$ pixels) in a data string constituting one code vector in a code book, a code vector is generated by giving a value which increases in an increment of a predetermined value from the reference data value K to each piece of the other data in the block. A greatly versatile code book can be made at least for data on a pattern, for example, a face image, whose data value gradually varies by a small change.

F I G. 3

(a)

(Cont. next page)

K   K+40

K+20   K+60

(b)

**Description**

Technical Field

The present invention relates to a method and apparatus for making a code book, a vector quantizing device, a device and method for data compression, a device and method for data decompression, a system for data compression/decompression, which are used for vector quantization, and a recording medium which stores a progran for executing these processes or a code book having a predetermined data structure.

Background Art

Various data compressing methods have been conventionally proposed. Of these methods, a method called "vector quantization" is well known as a data compression algorithm capable of very easily decompressing compressed data. This algorithm is known in the field of signal processing for a long time and particularly applied to data compression of an image or voice signal, or pattern recognition.

In this vector quantization, some pixel patterns (codes) each having a certain size (e.g., a block of $4 \times 4$ pixels) are prepared and respectively assigned unique numbers (this set is called a code book). For example, blocks having the same size (e.g., $4 \times 4$ pixels) are sequentially extracted from two-dimensional image data, and a pattern most similar to each block is extracted from the code book, and the pattern number is assigned to the block, thereby compressing the data. In vector quantization, a data string in one block corresponds to one vector.

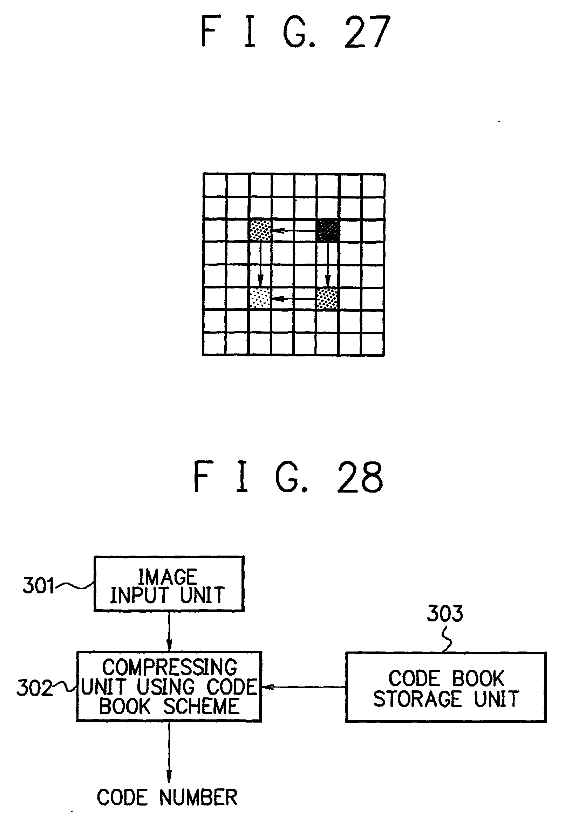

Fig. 28 is an illustration of the schematic construction of a conventional vector quantizing device. Referring to Fig. 28, an original image input by an image input unit 301 is supplied to a compressing unit 302 using a code book scheme. The compressing unit 302 using the code book scheme executes vector quantization processing, which will be described below, for the input original image using a number of pattern images (e.g., images each comprising a block of $4 \times 4$ pixels) which have been registered in a code book storage unit 303 as a code book in advance.

When the input original image is a still image, the compressing unit 302 using the code book scheme performs the following processing for the single still image. When the input original image is a moving picture, the following processing is sequentially executed for each frame image.

More specifically, starting from the upper left corner of the original image, $4 \times 4$ pixel blocks are sequentially extracted toward the right. When the extraction position reaches the right end, it is shifted to the lower side by one block, and blocks are extracted from the left end again. This is repeated to extract blocks of the entire window.

For each extracted block, a code vector having a pattern most similar to the block is selected out of many code vectors registered in the code book storage unit 303, and its corresponding code number is output. For example, when an image having $640 \times 480$ pixels is processed, 19,200 blocks are extracted and processed, so the number of code numbers to be output is also 19,200.

On the receiving or decompressing side of thus coded compressed data, the original image can be reconstructed only by extracting a pattern corresponding to the code number from the code book for each block. Hence, when the decompressing side has received or holds in advance the code book, the original image can be reconstructed by very simple hardware because no special arithmetic operation is necessary.

Subjects of the above-described vector quantization are, for example, in data compression of an image, how to obtain a high-quality reconstructed image while holding a high compression ratio, and how to make a code book with high performance, which is always required for execution of vector quantization. More specifically, because of the characteristics of vector quantization, the quality of a reconstructed image is closely related to the quality of a code book used. Hence, for example, to obtain a high-quality reconstructed image while holding a high compression ratio in data compression of an image, how to make a high-performance code book is a subject.

Conventionally, to optimize the code book, some methods are known, represented by the Kohonen self-organizing map method. In these methods, a code book is optimized by performing appropriate mathematical expression processing using, e.g., a sample image. However, in the conventional optimizing techniques, a resultant code book is useful for only data used for optimization.

More specifically, a code book optimized using image data of a person's face is the best code book for the image used for optimization. However, the code book is not always the best for other images. For example, when image data of another person's face is compressed using the code book, the quality of the image reconstructed from the compressed data deteriorates.

In addition, although a relatively high quality is obtained for a reconstructed image included in the same category "human face" as the image used for optimization, the image quality often degrades for an image in a different category such as "landscape" or "character". That is, since patterns included in the code book vary with images, the code book is not so versatile.

To obtain a satisfactory quality for a reconstructed image regardless of the category of images, a method is available in which a code book is optimized using various kinds of sample images, and all resultant code books are registered. In this case, in actually executing vector quantization, since code books matching images in various categories including "human", "landscape", and "character" are prepared in advance, a pattern close to the original image can be selected out of them.

In this case, however, the number of codes to be prepared in advance is enormous, and the capacity of a memory for storing them becomes very large. When the memory capacity becomes large, the scale of the entire apparatus also becomes large, resulting in difficulty in downsizing. In addition, since the cost also increases accordingly, employment of this method is impractical.

The above optimizing technique also has a problem that which types of patterns are included in the optimized code book cannot be known.

The present invention has been made to solve the above problems, and aims to realize a greatly versatile code book compatible with various kinds of images.

It is another object of the present invention to realize a greatly versatile code book without increasing the capacity of a memory for storing the code book.

It is still another object of the present invention to make it possible easily to recognize which kinds of patterns are included in an optimized code book.

In executing vector quantization, as described above, search processing for finding a code vector having a pattern similar to the vector data of an original image from a code book must be performed. As a means for determining whether two units of vector data are similar to each other, conventionally, the two units of vector data are input to a predetermined function and calculated to express the similarity between them as a numerical value, and determination is done on the basis of the magnitude of this numerical value.

As the predetermined function, a function for obtaining the Manhattan or Euclidean distance between the two units of vector data input is used. The Manhattan distance is obtained by calculating the absolute difference value between the two units of vector data input for individual elements and adding all absolute difference values calculated between the elements. The Euclidean distance is obtained by calculating the square-sum of such absolute difference values described above.

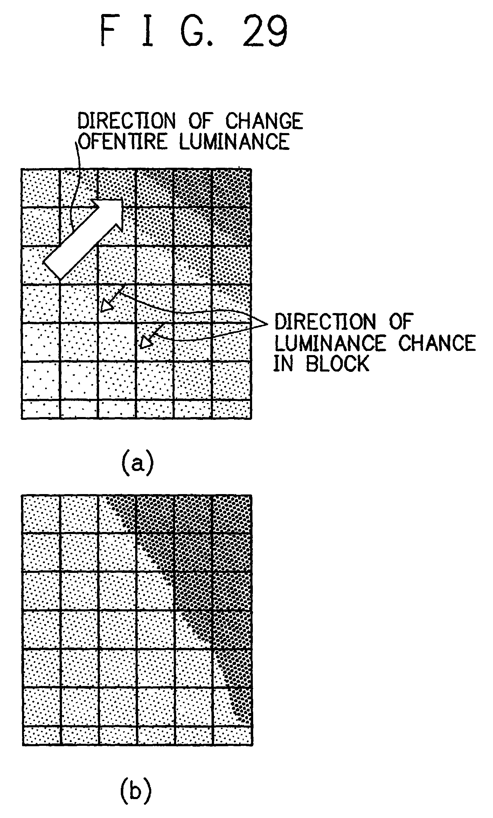

Fig. 29 are illustrations for explaining the problem of the prior art in which a code vector is searched for by obtaining similarity using such a method. Figs. 29(a) and (b) show parts of a reconstructed image reconstructed by embedding code vectors (pattern images of blocks) obtained by vector quantization, in each block. Squares shown in Fig. 29 correspond to individual blocks.

Fig. 29(a) shows a case wherein, although the original image (not shown) before compression is an image in which the entire luminance gradually changes in a direction (indicated by the large arrow) from the lower left block to the upper right block, the reconstructed image includes blocks having a pattern which changes the luminance in the opposite direction (indicated by the small arrows). Fig. 29(b) shows a part corresponding to an edge in the reconstructed image, though the edge portion is not satisfactorily reconstructed.

As described above, in the conventional vector quantizing technique, both the image whose luminance value gradually changes and the image whose luminance value abruptly changes are reconstructed as unnatural images for which a man has the sense of incompatibility for embedded patterns.

As one cause, since the conventional code book is not made in consideration of a pattern whose luminance value gradually changes or a pattern whose luminance value abruptly changes, as described above, a pattern image suitable to each image is not always included in the made code book.

As another probable cause, in conventional vector quantization, similarity is independently calculated for each block, and the similarity is obtained by calculating using information on all pixels in the block. More specifically, although code vectors having various patterns are included in a code book, the similarity to an input vector extracted from the original image is given for each block on the basis of the sum of absolute difference values for each pixel.

Hence, even a pattern whose luminance direction is opposite to that of the entire image is selected when the calculated similarity is larger than that for other patterns. That is, even when a code vector having a pattern image more natural as a whole is included in the code book, not this pattern but an unnatural pattern image is sometimes selected. When blocks with such pattern images are locally included in the reconstructed image, those who see the image have the sense of incompatibility.

The present invention has also been made to solve this problem, and aims to make it possible to obtain a high-quality reconstructed image by reliably searching for a pattern image suitable to the human visual characteristic.

Summary of the Invention

A method of making a code book used in vector quantization according to the present invention is a method of making a code book used in vector quantization, said code book comprising a set of code vectors each of which is a data string including at least one unit of data, characterized in that a data string of a code vector is made with reference to one or more units of data in the data string constituting the code vector, by giving, to the remaining units of data in the data string, values which vary from the reference data value in order by a predetermined increment.

Another aspect of the present invention is directed to a method of making a code book used in vector quantization. The code book comprises a set of code vectors each of which is a data string including at least one unit of data. The method is characterized in that a data string of a code vector is made by the manner that the data string constituting the code vector is classified into data groups, the total range of the possible values of the respective units of data in the data string is divided by the number of classified data groups, and an arbitrary value in the divided range corresponding to the data group is selectively assigned as each data value in each data group.

Still another aspect of the present invention is directed to a method of making a code book used in vector quantization. The code book comprises a set of code vectors each of which is a data string including at least one unit of data. The method is characterized in that a data string of a code vector is made by the manner that the occupation rate of the maximum or minimum value of the possible values of the respective units of data in the data string constituting the code vector is set, the maximum or minimum value is assigned to arbitrary units of data constituting the data string in accordance with the set rate, and the minimum or maximum value is assigned to the other units of data than the units of data to which the maximum or minimum value is assigned.

An intermediate value may be assigned to predetermined units of data in accordance with the arrangement state of the units of data to which the minimum value is assigned.

According to still another aspect of the present invention, the method is characterized by including at least two of the above-described three code book making methods and characterized in that code books made by at least two methods are combined to make one code book.

An apparatus for making a code book used in vector quantization of the present invention is an apparatus for making a code book used in vector quantization, said code book comprising a set of code vectors each of which is a data string including at least one unit of data, characterized by comprising: reference value setting means for setting a reference data value to one or more arbitrary units of data in a data string constituting a code vector; increment setting means for setting an increment with respect to the reference data value; and code vector making means for making the data string of the code vector as a set of data values obtained by sequentially changing the set reference data value by the set increment.

Another aspect of the present invention is directed to an apparatus for making a code book used in vector quantization. The code book comprises a set of code vectors each of which is a data string including at least one unit of data. The apparatus is characterized by comprising: data classifying means for classifying a data string constituting a code vector into data groups; range dividing means for dividing the total range of the possible values of the respective units of data in the data string by the number of classified data groups; and code vector making means for making the data string of the code vector by selectively assigning, as each data value in each classified data group, an arbitrary value in the divided range corresponding to the data group.

Still another aspect of the present invention is directed to an apparatus for making a code book used in vector quantization. The code book comprises a set of code vectors each of which is a data string including at least one unit of data. The apparatus is characterized by comprising: rate setting means for, in a data string constituting a code vector, setting the occupation rate of the maximum or minimum value of the possible values of the respective units of data in the data string; and code vector making means for making the data string of the code vector by assigning the maximum or minimum value to arbitrary units of data constituting the data string in accordance with the set rate and assigning the minimum or maximum value to the other units of data than the units of data to which the maximum or minimum value is assigned.

The code vector generating means may assign an intermediate value to predetermined units of data in accordance with the arrangement state of the units of data to which the minimum value is assigned.

According to still another aspect of the present invention, the apparatus is characterized by comprising means for combining code books made by at least two of the above-described code vector generating means to make one code book.

A computer-readable recording medium of the present invention is characterized by storing a program for causing a computer to execute at least one of the above-described various code book making procedures.

Still another aspect of the present invention is characterized by storing a code book made by the above-described various code book making procedures.

In the present invention, as described above, with reference to one or more units of data in the data string constituting the vector, a code vector is generated by giving a value which increases in an increment of a predetermined value from the reference data value to each unit of the other data in the data string. Hence, a greatly versatile code book can easily be made at least for data on a pattern, for example, data of a face image, whose data value gradually varies by a small change. In addition, since individual code vectors constituting the code book are generated in accordance with predetermined arithmetic operation, which kinds of patterns are included in the made code book can easily be recognized.

According to another characteristic feature of the present invention, one code vector is generated by classifying the data string constituting the vector into data groups, dividing the total range of possible values of the respective units of data in the data string by the number of classified data groups, and selectively assigning, as each data value in each data group, an arbitrary value in the divided range corresponding to the data group. Hence, a greatly versatile code book can easily be made at least for data on a pattern, for example, data of a landscape image, whose data value gradually varies by a relatively large change. In addition, which kinds of patterns are included in the made code book can easily be recognized.

According to still another characteristic feature of the present invention, one code vector is generated by, in the data string constituting the vector, setting the ratio of the maximum value or minimum value of possible values of the respective units of data in the data string, assigning the maximum value or minimum value to arbitrary units of data constituting the data string in accordance with the set ratio, and simultaneously assigning the minimum value or maximum value to each unit of data other than the units of data assigned the maximum value or minimum value. Hence, a greatly versatile code book can easily be made at least for data on a pattern, for example, data of a character image, whose data value abruptly varies. In addition, which kinds of patterns are included in the made code book can easily be recognized.

According to still another characteristic feature of the present invention, since code books made by at least two methods of the above-described code book making methods are combined to make one code book, a more versatile code book can easily be made.

As described above, according to the present invention, by giving a desired value to code vector data, a greatly versatile code book capable of coping with various data including data which monotonically varies or data which abruptly varies can be realized. When the code book made by the present invention is used, a greatly versatile system for data compression/decompression, which can reconstruct, for various images, high-quality images even at a high compression ratio, can be implemented.

An apparatus for making a code book used in vector quantization according to still another aspect of the present invention is an apparatus for making a code book used in vector quantization, said code book comprising a set of vectors each of which is a data string including at least one unit of data, characterized by comprising: solid pattern generating means for generating at least one type of solid pattern code whose data value gradually varies in a block constituting the vector; and edge pattern generating means for generating at least one type of edge pattern code whose data value abruptly varies in the block.

According to still another aspect of the present invention, the apparatus is characterized by comprising storage means for storing the pattern codes generated by the solid pattern generating means and the edge pattern generating means, and code calculating means for, in executing the vector quantization, performing arithmetic operation for the pattern codes stored in the storage means to generate pattern codes different from the pattern codes.

A method of making a code book used in vector quantization according to still another aspect of the present invention is a method of making a code book used in vector quantization, said code book comprising a set of vectors each of which is a data string including at least one unit of data, characterized in that: at least one type of solid pattern code whose data value gradually varies in a block constituting a vector and at least one type of edge pattern code whose data value abruptly varies in the block, are generated as basic patterns and stored in storage means; and in executing the vector quantization, pattern codes different from the basic patterns are generated by performing arithmetic operation for the pattern codes stored in the storage means.

Still another aspect of the present invention is directed to a method of making a code book used in vector quantization. The code book comprising a set of vectors each of which is a data string including at least one unit of data. The method is characterized in that: at least one type of solid pattern code is generated in advance as a basic pattern and stored in storage means; and, in executing the vector quantization, a pattern code different from the basic pattern is generated by performing arithmetic operation for the at least one type of pattern code which is stored in the storage means.

A vector quantizing device of the present invention is a vector quantizing device which forms, as a vector, a block from a data string including at least one unit of data, searches for a code vector similar to the vector extracted from a compression target from a code book prepared in advance, and outputs a code corresponding to the code vector, characterized by comprising: solid pattern generating means for generating at least one type of solid pattern code whose data value gradually varies in the block; edge pattern generating means for generating at least one type of edge pattern code whose data value abruptly varies in the block; storage means for storing the pattern codes generated by said solid pattern generating means and said edge pattern generating means; code calculating means for, in executing the vector quantization, performing arithmetic operation for the pattern codes stored in said storage means to generate pattern codes different from the pattern codes; and vector quantizing means for executing the vector quantization using the pattern codes read out from said storage means and the pattern codes generated by said code calculating means.

According to still another aspect of the present invention, a vector quantizing device which forms, as a vector, a block from a data string including at least one unit of data, searches for a code vector similar to the vector extracted from a compression target from a code book prepared in advance, and outputs a code corresponding to the code vector, is characterized by comprising: storage means for storing the code book; calculating means for, in executing the vector quantization, performing arithmetic operation for codes stored in said storage means to generate codes different from the stored codes; and vector quantizing means for executing the vector quantization using the codes read out from said storage means and the codes generated by said calculating means.

A computer-readable recording medium of the present invention is characterized by recording a program for causing a computer to execute the processing procedure of the code book making method according to claim 32 or 33.

According to still another aspect of the present invention, a recording medium which records a vector quantization program for forming, as a vector, a block from a data string including at least one unit of data, searching for a code vector similar to the vector extracted from a compression target from a code book prepared in advance, and outputting a code corresponding to the code vector, is characterized in that said computer-readable recording medium records a program for causing a computer to execute: the calculating step of, in executing the vector quantization, performing arithmetic operation for codes stored in storage means to generate codes different from the stored codes; and the vector quantizing step of executing the vector quantization using the codes read out from the storage means and the codes generated in the calculating step.

According to the present invention, as described above, a solid pattern code whose data value gradually varies in a block and an edge pattern code whose data value abruptly varies in a block are generated as basic patterns, thereby making it possible to cope with various images constructed by combinations of the code vector and edge pattern.

In addition, according to another characteristic feature of the present invention, the basic patterns are generated and stored in advance, and, in executing vector quantization, arithmetic operation is performed for the pattern codes stored to generate pattern codes different from the basic patterns. Hence, various pattern codes are generated by arithmetic operation in executing vector quantization, a pattern code closer to the original image can be applied, and the quality of the reconstructed image can be improved. Since only the basic patterns need be stored in the storage means, the memory capacity can be suppressed.

As described above, according to the present invention, a greatly versatile code book capable of coping with various images can be realized without increasing the memory capacity for storing it.

A device for data compression of the present invention is a device for data compression, which forms, as a vector, a block from a data string including at least one unit of data, searches for a code vector similar to the vector extracted from a compression target from a code book prepared in advance, and outputs a code corresponding to the code vector, is characterized by comprising: code book storage means for storing a code book prepared for every different type of pattern; discriminating means for discriminating a type of pattern of data of the block on the basis of information in the block of the compression target; and vector quantizing means for executing vector quantization processing using the code books prepared for the respective patterns in accordance with a discrimination result by said discriminating means.

The discriminating means discriminates, for example, on the basis of data values of elements in the block of the compression target, between a first pattern whose data value gradually varies in a certain direction in the block and a second pattern whose data value abruptly varies in the block.

For example, when the difference between the maximum and minimum values of the elements in the block is smaller than a predetermined threshold value, the block is discriminated as the first pattern, and when the difference between the maximum and minimum values in the block is larger than the predetermined threshold value, the block is discriminated as the second pattern.

The vector quantizing means may obtain similarity for the blocks of the patterns of different types by different processes.

In this case, for the first pattern in which the data value of each element in the block of the compression target gradually varies, the vector quantizing means obtains the similarity using only data values of elements at four corners in a rectangular block.

In addition, a direction of data value change in the block may be detected from the data values at the four corners in the block, and the similar code vector may be searched for in consideration of the direction.

In executing vector quantization using the pieces of information at the four corners, each code vector constituting the code book for the first pattern may be formed from only pieces of information on the elements at the four corners in the block.

A device for data decompression of the present invention is a device for data decompression which uses a data string including at least one unit of data as a vector, searches for a code vector corresponding to a compression code from a code book including at least one code vector, and assigns the code vector to a corresponding block position to reconstruct original data, is characterized by comprising: code book storage means for storing a code book prepared for every different type of pattern; and decoding means for, on the basis of compression codes generated on the compressing side for the respective patterns of different types, searching for code vectors corresponding to the compression codes from the code books prepared for the respective patterns.

The different types of patterns include a first pattern in which the data value of each element in the block of the compression target gradually varies in a certain direction in the block and a second pattern in which the data value abruptly varies in the block.

Each code vector constituting the code book for the first pattern may be formed from only pieces of information on the elements at the four corners in the rectangular block.

In this case, the device may comprise calculating means for calculating, by arithmetic operation, pieces of information on other elements on the basis of the pieces of information on the elements at the four corners in the block.

A method for data compression of the present invention is a method for data compression in which a block is formed, as a vector, from a data string including at least one unit of data, a code vector similar to the vector extracted from a compression target is searched from a code book prepared in advance, and a code corresponding to the code vector is output, characterized in that: a type of pattern of data in the block of the compression target is discriminated on the basis of information in the block and vector quantization processing is executed using code books prepared for the respective patterns in accordance with a discrimination result.

According to still another aspect of the present invention, in executing the vector quantization processing, for the blocks of the patterns of different types, similarities of vectors may be obtained by different processes, and for the first pattern, the similarity may be obtained using only data values of elements at four corners in a rectangular block.

In addition, a direction of data value change in the block may be detected from the data values at the four corners in the block, and the similar code vector may be searched for in consideration of the direction.

A method for data compression of the present invention is a method for data decompression in which a data string including at least one unit of data is used as a vector, a code vector corresponding to a compression code is searched from a code book including at least one code vector, and the code vector is assigned to a corresponding block position to reconstruct original data, characterized in that: on the basis of compression codes generated on the compressing side for the respective different types of patterns, code vectors corresponding to the compression codes are searched from code books prepared for the respective patterns.

According to still another aspect of the present invention, each code vector constituting the code book for the first pattern may have only pieces of information on the elements at the four corners in a rectangular block, and in searching for the code vector corresponding to the compression code and assigning the code vector to the corresponding block position, pieces of information on other elements may be calculated by arithmetic operation on the basis of the pieces of information on the elements at the four corners in the block.

A system for data compression/decompression of the present invention is a system for data compression/decompression including a device for data compression which forms, as a vector, a block from a data string including at least one unit of data, searches for a code vector similar to the vector extracted from a compression target from a code book prepared in advance, and outputs a code corresponding to the code vector, and a device for data decompression which searches for a code vector corresponding to the code from the code book and assigns the code vector to a corresponding block position to reconstruct original data, characterized in that said device for data compression comprises first code book storage means for storing a code book prepared for every different type of pattern, discriminating means for discriminating a type of pattern of data of the block on the basis of information in the block of the compression target, and vector quantizing means for executing vector quantization processing using the code books prepared for the respective patterns in accordance with a discrimination result by said discriminating means; and said device for data decompression comprises second code book storage means for storing a code book prepared for every different type of pattern, and decoding means for, on the basis of compression codes generated on the compressing side for the respective patterns of different types, searching for code vectors corresponding to the compression codes from the code books prepared for the respective patterns.

Each of the first and second code book storage means may store the code books of the patterns of different types in a single storage device.

Alternatively, each of the first and second code book storage means may separately store the code books of the patterns of different types in storage devices, and information for identifying a pattern may be supplied to the device for data decompression together with the code generated by the device for data compression.

A computer-readable recording medium of the present invention is characterized by recording a program for causing a computer to function as each of the above-described means or a program for causing a computer to realize the above-described functions.

Still another aspect of the present invention is characterized by recording a program for causing a computer to execute the processing procedure of the above-described method for data compression or method for data decompression.

In the present invention, as described above, in executing vector quantization, patterns are discriminated on the basis of information in a block extracted from a compression target, and vector quantization is executed using appropriate code books prepared for the respective patterns. Hence, for example, when an image is compressed, and the image is reconstructed using a selected code vector, a more natural reconstructed image according to the human visual characteristic can be obtained.

According to still another aspect of the present invention, for a solid pattern, similarity is calculated using only information at the four corners in the block, and simultaneously, the direction of change in the block is detected, and a code vector is selected on the basis of the result. Hence, a disadvantage that an unnatural code vector whose data value in the block varies in a direction opposite to that of the change in the entire image is selected can be properly prevented, and a reconstructed image having a higher quality can be obtained.

Brief Description of the Drawings

Fig. 1 is a function block diagram showing the construction of an apparatus for making a code book for a face image according to the first embodiment;

Fig. 2 is a flow chart showing the operation of the apparatus for making a code book for a face image according to the first embodiment;

Fig. 3 shows conceptional views for explaining a method of making the code book for a face image according to the first embodiment, in which (a) is a view showing a pattern, and (b) is a view showing a state wherein the luminance value changes by 20 per pixel;

Fig. 4 is a graph showing the comparison result of PSNR characteristic between a code book made in the first embodiment and a code book individually optimized by the Kohonen self-organizing map method;

Fig. 5 is a function block diagram showing the construction of an apparatus for making a code book for a landscape image according to the second embodiment;

Fig. 6 is a flow chart showing the operation of the apparatus for making a code book for a landscape image according to the second embodiment;

Fig. 7 shows conceptional views for explaining a method of making the code book for a landscape image according to the second embodiment, in which (a) is a view showing a pattern whose luminance value gradually increases from the upper left corner of the block to the lower right corner, and (b) is a view showing a state wherein the dynamic range of luminance values of 0 to 255 are divisionally defined in five ranges in accordance with five regions A to E;

Fig. 8 is a function block diagram showing the construction of an apparatus for making a code book for a character image according to the third embodiment;

Fig. 9 is a flow chart showing the operation of the apparatus for making a code book for a character image according to the third embodiment;

Fig. 10 shows conceptional views for explaining a method of making the code book for a character image according to the third embodiment, in which is a view showing the first pattern, (b) is a view showing the second pattern, (c) is a view showing the third pattern, and (d) is a view showing the fourth pattern;

Fig. 11 is a graph showing the comparison result of PSNR characteristic between a code book made in the fourth embodiment and a code book individually optimized by the Kohonen self-organizing map method;

Fig. 12 is a block diagram showing the construction of an apparatus for making a code book for a character image according to the fifth embodiment;

Fig. 13 is a block diagram showing the construction of a vector quantizing device according to the fifth embodiment;

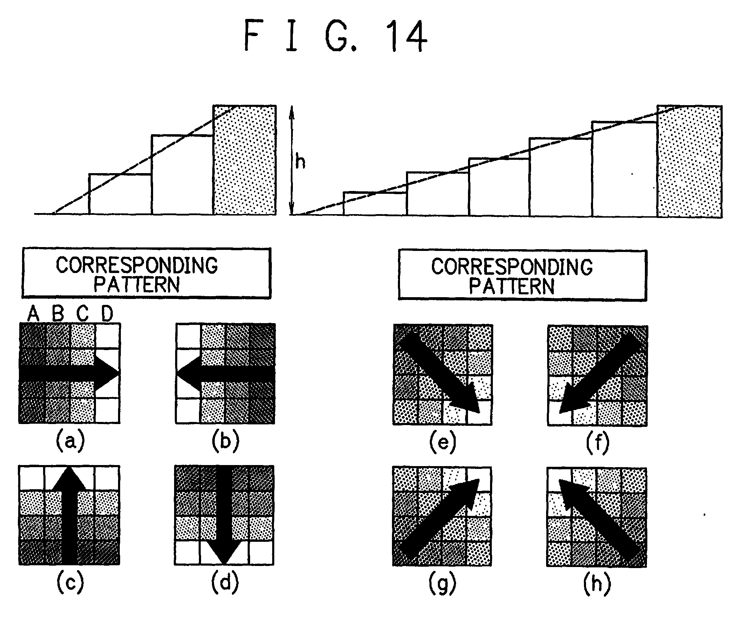

Fig. 14 shows illustrations of examples of solid patterns to be generated, in which (a) is an illustration showing a pattern whose luminance value gradually increases in the order of A → B → C → D from the left side to the right side of the block in units of vertical lines, (b) is an illustration showing a pattern whose luminance value gradually increases from the right side to the left side of the block in units of vertical lines, (c) is an illustration showing a pattern whose luminance value gradually increases from the lower side to the upper side of the block in units of horizontal lines, (d) is an illustration showing a pattern whose luminance value gradually increases from the upper side to the lower side of the block in units of horizontal lines, (e) is an illustration showing a pattern whose luminance value gradually increases from the upper left corner to the lower right corner of the block in units of oblique lines, (f) is an illustration showing a pattern whose luminance value gradually increases from the upper right corner to the lower left corner of the block in units of oblique lines, (g) is an illustration showing a pattern whose luminance value gradually increases from the lower left corner to the upper right corner of the block in units of oblique lines, and (h) is an illustration showing a pattern whose luminance value gradually increases from the lower right corner to the upper left corner of the block in units of oblique lines;

Fig. 15 is an illustration showing examples of codes of basic patterns of edges to be generated;

Fig. 16 is a flow chart showing the procedure of generating a basic solid pattern;

Fig. 17 is a flow chart showing the procedure of generating a basic edge pattern;

Fig. 18 is a flow chart showing the procedure of executing vector quantization;

Fig. 19 is a block diagram showing a construction of a system for data compression/decompression according to the sixth embodiment;

Fig. 20 is an illustration for explaining the operation principle of vector quantization according to the sixth embodiment;

Fig. 21 shows illustrations of examples of code vectors (pattern images) constituting a code book, in which (a) is an illustration showing a case wherein code vectors of patterns which monotonically change in eight directions are registered, and (b) is an illustration showing a case wherein code vectors whose luminance values abruptly change are registered;

Fig. 22 is a flow chart showing an example of data compressing operation;

Fig. 23 is a flow chart showing an example of data decompressing operation;

Fig. 24 is a block diagram showing another construction of the system for data compression/decompression;

Fig. 25 is a flow chart showing another example of data compressing operation;

Fig. 26 is a flow chart showing another example of data decompressing operation;

Fig. 27 is an illustration for explaining the seventh embodiment;

Fig. 28 is a block diagram showing the construction of a conventional vector quantizing device; and

Fig. 29 shows illustrations for explaining conventional problems, in which (a) and (b) are illustrations showing parts of a reconstructed image reconstructed by embedding code vectors (pattern images of blocks) obtained by vector quantization in units of blocks.

Detailed Description of the Preferred Embodiments

An embodiment of the present invention will be described below with reference to drawings.

(First Embodiment)

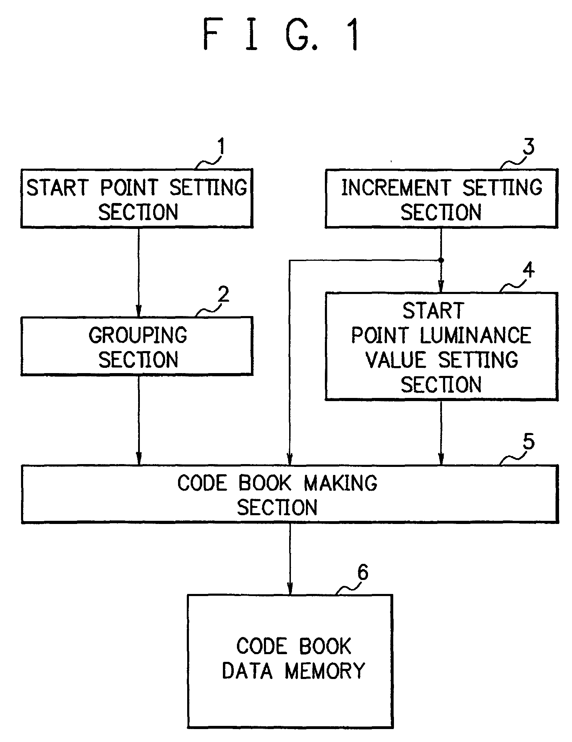

In the first embodiment, an apparatus and method for making a code book for, e.g., a face image will be described. Fig. 1 is a function block diagram showing the construction of the apparatus for making the code book according to this embodiment.

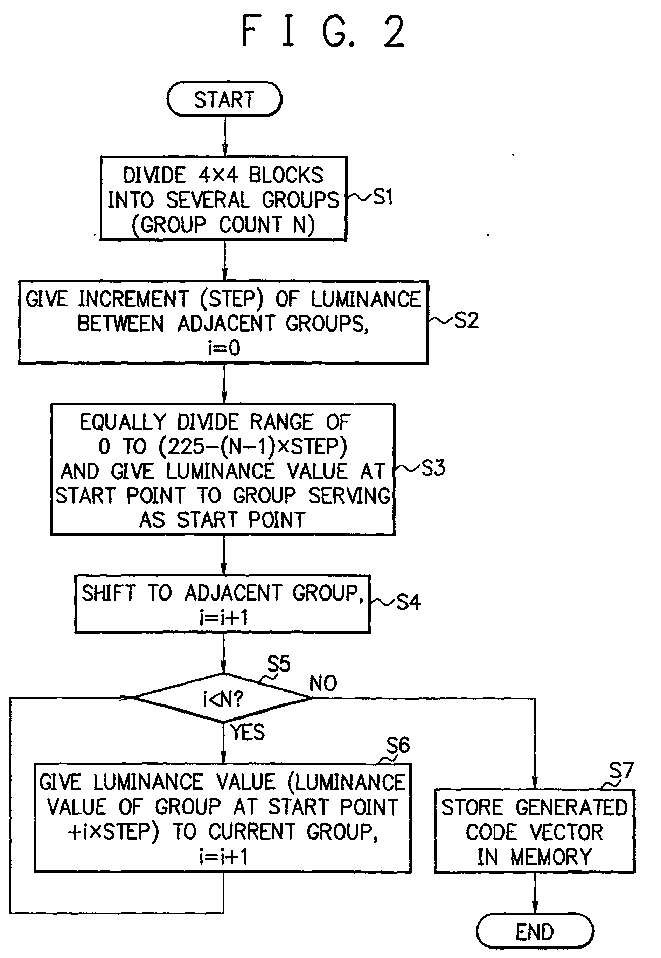

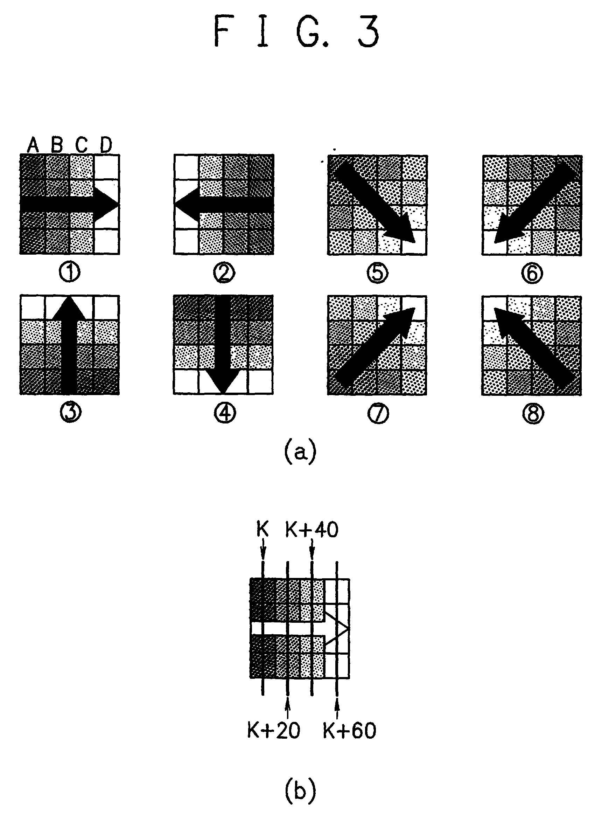

Fig. 2 is a flow chart showing the operation of the apparatus for making the code book according to this embodiment. Fig. 3 shows conceptional views for explaining the method of making the code book according to this embodiment.

Generally, most parts of a face image are occupied by patterns whose pixel values smoothly change as a whole. The change is monotonic and very little. In this embodiment, as typical code patterns of a face image code book, patterns which monotonically change in eight directions are generated, as shown in Fig. 3.

More specifically, a set of pixel values, which is formed from, e.g., a block of 4 pixels × 4 pixels is defined as one vector (to be referred to as a code vector hereinafter) in a code book, and a pattern whose pixel value (e.g., luminance value) in the block gradually changes from one of the edge portions (upper, lower, left, and right sides and four corner points) of the block is generated. In this case, a $4 \times 4$ pixel code vector is generated as an example. However, the present invention is not limited to this size.

Referring to Fig. 3(a), pattern ① is a pattern whose luminance value gradually increases, as A → B → C → D, from the left side to the right side of the block in units of vertical lines. As the degree of change, for example, the luminance value changes by 20 per pixel, as shown in Fig. 3(b). More specifically, letting K be the luminance value at the left end in the block, the luminance values at the second line, third line, and right end are K + 20, K + 40, and K + 60, respectively.

In this embodiment, 20 is defined as the maximum value of the degree of change in luminance value, and a pattern is generated while changing the degree to various values such as 10, 5, 2, and 1. For the luminance value K of the pixel at the start point of change, the minimum and maximum values of possible values are given, and values appropriately dispersed therebetween are given. This generates variations in pattern whose luminance value gradually changes from the left side to the right side in the block, like pattern ①. The step width of the luminance value which gradually changes is not limited to the above-described examples.

This also applies to the remaining patterns ② to ⑧, though only pattern ① shown in Fig. 3(a) has been described above in detail. Pattern ② is a pattern whose luminance value gradually increases from the right side to the left side of the block in units of vertical lines, pattern ③ is a pattern whose luminance value gradually increases from the lower side to the upper side of the block in units of horizontal lines, and pattern ④ is a pattern whose luminance value gradually increases from the upper side to the lower side of the block in units of horizontal lines.

Pattern ⑤ is a pattern whose luminance value gradually increases from the upper left corner to the lower right corner of the block in units of oblique lines, pattern ⑥ is a pattern whose luminance value gradually increases from the upper right corner to the lower left corner of the block in units of oblique lines, pattern ⑦ is a pattern whose luminance value gradually increases from the lower left corner to the upper right corner of the block in units of oblique lines, and pattern ⑧ is a pattern whose luminance value gradually increases from the lower right corner to the upper left corner of the block in units of oblique lines. In these patterns ① to ⑧, the luminance value gradually changes in seven steps.

The function/construction and operation of the apparatus for generating code vectors as shown in Fig. 3 will be described next with reference to the block diagram shown in Fig. 1 and the flow chart shown in Fig. 2.

Referring to Fig. 2, first in step S1, for example, a $4 \times 4$ pixel block is classified into several groups (the number of groups is N). For example, to generate the code vector of pattern ① shown in Fig. 3(a), the block is divided into four groups A to D in units of vertical lines.

In performing this grouping, first, a start point in the block is set using a start point setting section 1 shown in Fig. 1. For example, to generate pattern ① shown in Fig. 3(a), the four pixels (group A) at the left side in the block are set as a start point. Note that the start point setting section 1 can be constructed by an input device such as a keyboard or a mouse to cause the user to set an arbitrary start point. Alternatively, the apparatus itself may automatically set the start point in order sequentially to generate the eight patterns ① to ⑧ shown in Fig. 3(a).

A grouping section 2 performs grouping in accordance with the start point set by the start point setting section 1. For example, to generate pattern ① or ② shown in Fig. 3(a), grouping is performed in units of lines in the vertical direction, or to generate pattern ③ or ④, grouping is performed in units of lines in the horizontal direction. To generate patterns ⑤ to ⑧, grouping is performed in units of lines in the oblique directions.

Next in step S2, the increment (step) of the luminance value between adjacent groups is set using an increment setting section 3 shown in Fig. 1. The increment setting section 3 can also be constructed by an input device such as a keyboard or a mouse to cause the user to set an arbitrary increment, or the apparatus itself may automatically set a predetermined default value. In step S2, processing of initializing a count value i for counting the number of processed groups to 0 is also performed.

In step S3, a start point luminance value setting section 4 shown in Fig. 1 sets the luminance value at the start point in the block. To give the luminance value at the start point, for example, the range of

$$0 \text{ to (maximum luminance value (= 255) - (N - 1)} \times \text{step)}$$

is equally divided into n parts, and each equally divided value is set as the luminance value at the start point. Although the equally divided value is given here, it need not always be the equally divided value as far as it falls within the range of 0 to $(255 - (N - 1) \times \text{step})$. In addition, although luminance values are given here by arithmetic operation, the user may arbitrarily input the luminance value at the start point within the above range by his/her discretion.

When necessary pieces of information including the luminance value at the start point and the increment of luminance, are set, these pieces of information are supplied to a code book making section 5 shown in Fig. 1. The code book making section 5 executes processing from step S4 shown in Fig. 2, thereby generating one code vector. More specifically, as the luminance value as the start point in one code vector is set in processing until step S3, processing shifts to the group adjacent to the start point, and the count value i is incremented by one in step S4.

In step S5, it is determined whether the count value i is smaller than the value of group count N. If YES in step S5, an unprocessed group remains, and therefore the flow advances to step S6 to give a luminance value calculated by (the luminance value of the group at the start point + i × step) to the current group. The count value i is incremented by one, and the flow returns to step S5. This processing is repeated until no unprocessed group remains.

When luminance values are given to all groups, the code vector of the pattern whose luminance value gradually increases from the start point to the end point in units of groups is generated. In this case, the flow advances to step S7 to store the code vector generated at this time in a code book data memory 6 shown in Fig. 1.

As described above, when one cycle of processing shown in the flow chart of Fig. 2 is ended, one code vector is generated and stored in the code book data memory 6. When such processing is executed two or more times while changing the start point position, the luminance value at the start point, and the value of increment in the block in various ways, code vectors having different luminance values are generated for the eight patterns ① to ⑧ shown in Fig. 3(a). The set of the code vectors is a code book for a face image. The code book size is, e.g., 512.

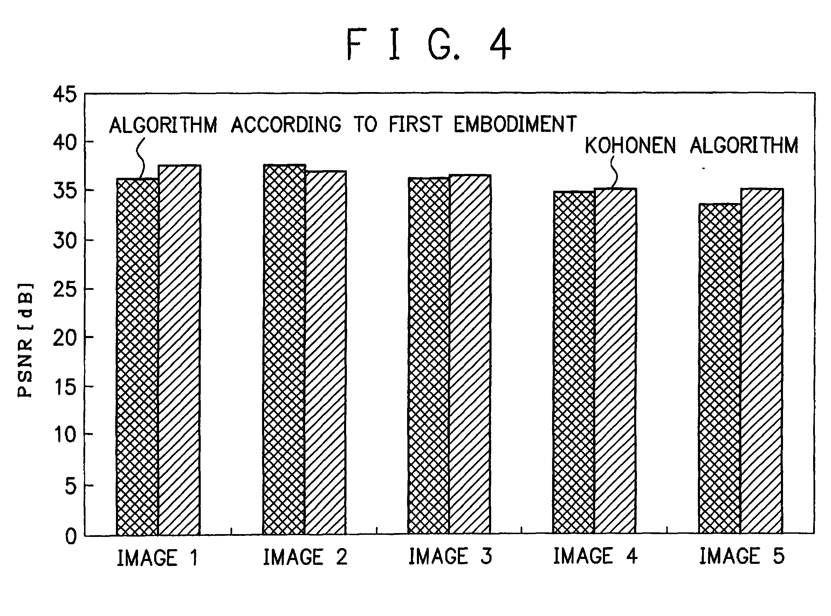

Fig. 4 is a graph showing the PSNR (Peak Signal to Noise Ratio) characteristics of images which are obtained when vector quantization (VQ) is executed for five face images using the code book having a size of 512, which is made by the method of this embodiment, and then, the images are reconstructed using the same code book as that used for VQ. Fig. 4 also shows, as a reference, the PSNR characteristics of the images, which are obtained when the code book is individually optimized using the images by the Kohonen self-organizing map method, VQ processing is executed for each image using a corresponding code book, and then each image is reconstructed using the same code book as that used for VQ.

As is apparent from the result shown in Fig. 4, the PSNR characteristic obtained in use of one code book made by the method of this embodiment is equivalent to that obtained in use of the five code books made by the Kohonen algorithm. As described above, according to this embodiment, even one code book can provide almost the same PSNR characteristic as that obtained when optimum code books are made by the Kohonen algorithm for the respective face images, so a greatly versatile code book can be made.

As described above, according to the first embodiment, a greatly versatile code book compatible to various face images with only one code book can be obtained. Additionally, in this embodiment, since each code vector is generated in accordance with a predetermined arithmetic operation pattern, which pattern is included in the optimized code book can easily be recognized.

In the above embodiment, a pattern whose luminance value gradually increases from the start point to the end point in a block is generated. Conversely, a pattern whose luminance value gradually decreases may be generated.

In this embodiment, the maximum value of the degree of change is 20. However, 20 need not always be used, and an arbitrary value such as 40 or 10 is appropriately given. The code book size need not always be 512, either.

(Second Embodiment)

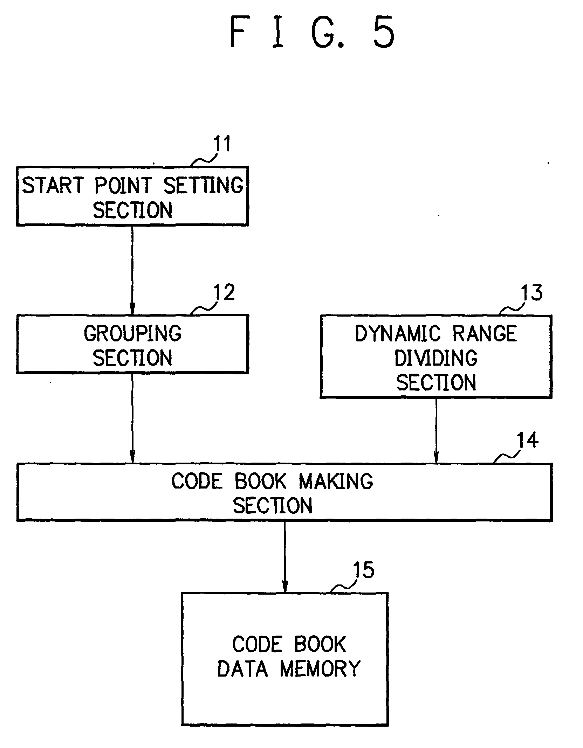

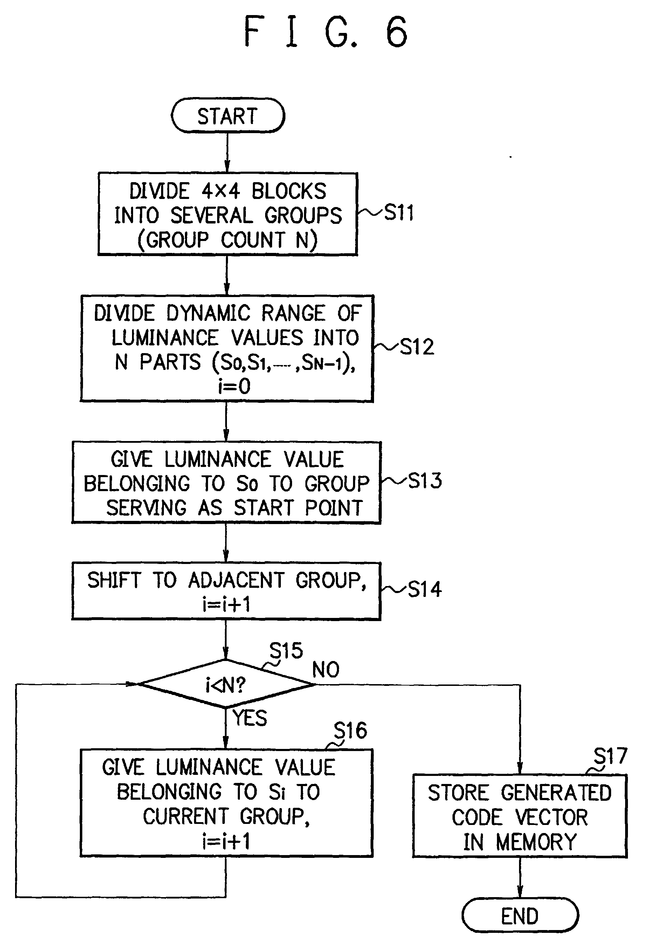

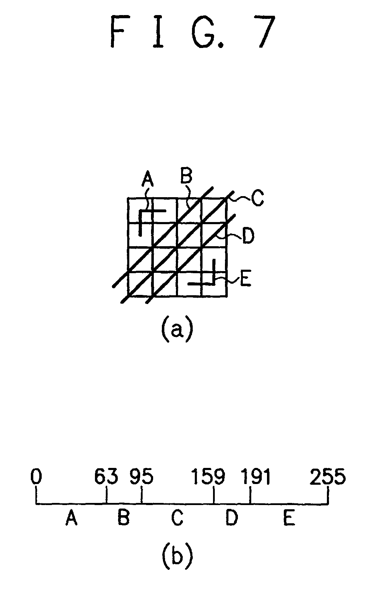

In the second embodiment, an apparatus and method for making a code book for, e.g., a landscape image will be described. Fig. 5 is a function block diagram showing the construction of the apparatus for making the code book according to this embodiment. Fig. 6 is a flow chart showing the operation of the apparatus for making the code book according to this embodiment. Fig. 7 shows conceptual views for explaining the method of making the code book for a landscape image according to this embodiment.

When a landscape image was checked, many patterns had pixel values monotonically changed, like the typical patterns of a face image, and they included many patterns whose degree of change was very large. In this embodiment, the code vector of a pattern whose luminance value gradually changes in a block and which uses almost the entire dynamic range of luminance values is generated.

More specifically, using a pattern in which the start point is set at one of the four corners of a block while the end point is set on the diagonal side, and the luminance value gradually changes, a block is divisionally defined in, e.g., five regions. On the other hand, the dynamic range of luminance values of 256 levels is divisionally defined in five ranges. By appropriately giving the luminance values in the regions of the block within corresponding level ranges, patterns for a landscape image are generated. In this embodiment, as such patterns for a landscape image, patterns whose luminance values gradually change in four directions starting from the four corners of the block are generated.

Fig. 7(a) shows a pattern whose luminance value gradually increases from the upper left corner to the lower right corner of the block. As shown in Fig. 7(a), a block formed from 4 pixels × 4 pixels is obliquely segmented into five regions A to E. On the other hand, as shown in Fig. 7(b), the dynamic range of luminance values from 0 to 255 is divisionally defined in five ranges corresponding to the five regions A to E, respectively.

In this example, luminance values of 0 to 63 are defined for the region A, luminance values of 63 to 95 are defined for the region B, luminance values of 95 to 159 are defined for the region C, luminance values 159 to 191 are defined for the region D, and luminance values of 191 to 255 are defined for the region E. As the luminance value of each of the regions A to E in the block, a value belonging to the level range assigned to each region is appropriately selected and given, thereby generating a pattern for a landscape image.

The function/construction and operation of the apparatus for generating the code vector as shown in Fig. 7 will be described next with reference to the block diagram shown in Fig. 5 and the flow chart shown in Fig. 6.

Referring to Fig. 6, first in step S11, for example, a 4 × 4 pixel block is classified into several groups (the number of groups is N). For example, to generate the code vector of the pattern shown in Fig. 7(a), pixels in the block are divided into five groups A to E.

In performing this grouping, first, a start point in the block is set using a start point setting section 11 shown in Fig. 5. For example, to generate the pattern shown in Fig. 7(a), three pixels at the upper left corner in the block are set as a start point. Note that the start point setting section 11 can be constructed by an input device such as a keyboard or a mouse to cause the user to set an arbitrary start point. Alternatively, the apparatus may automatically set the start point in order sequentially to generate patterns changing in four directions. A grouping section 12 performs grouping in accordance with the start point set by the start point setting section 11.

In step S12, the dynamic range of luminance values is divided into N parts $(S_0, S_1,..., S_{N-1})$ using a dynamic range dividing section 13 shown in Fig. 5 in accordance with the N regions after grouping. In step S12, processing of initializing a count value i for counting the number of processed groups to 0 is also performed. When grouping of a block and division of the dynamic range are performed, these pieces of information are supplied to a code book making section 14 shown in Fig. 1.

The code book making section 14 executes processing from step S13 shown in Fig. 6, thereby generating one code vector. More specifically, in step S13, for the group as the start point (group A in the example shown in Fig. 7), a luminance value belonging to the luminance level range $S_0$ corresponding to the group is set. In step S14, processing shifts to the group (group B in the example shown in Fig. 7) adjacent to the start point, and the count value i is incremented by one.

In step S15, it is determined whether the count value i is smaller than the value of group count N. If YES in step S15, an unprocessed group remains, and therefore the flow advances to step S16 to set, for the current group, a luminance value belonging to the luminance level range $S_1$ corresponding to the group. The count value i is incremented by one, and the flow returns to step S15. This processing is repeated until no unprocessed group remains.

When luminance values are given to all groups, the code vector of the pattern whose luminance value gradually increases from the start point to the end point in units of groups is generated. In this case, the flow advances to step S17 to store the code vector generated at this time in a code book data memory 15 shown in Fig. 5.

As described above, when one cycle of processing shown in the flow chart of Fig. 6 is ended, one code vector is generated and stored in the code book data memory 15. When such processing is executed two or more times while changing the luminance value at the start point position in the block and the luminance value to be given to pixels in each region in various ways, code vectors having different luminance values are generated as the code vectors of patterns which change in four directions. The set of the code vectors is a code book for a landscape image.

Although not illustrated here, when the code book made in this embodiment was applied to landscape images of several types, as in the first embodiment, a PSNR characteristic almost the same as that of a code book optimally made by the Kohonen algorithm for each landscape image was obtained, and a relatively satisfactory PSNR characteristic was obtained.

As described above, according to the second embodiment, a greatly versatile code book compatible to various landscape images with only one code book can be obtained. Additionally, in this embodiment, since each code vector is generated in accordance with a predetermined pattern, which pattern is included in the optimized code book can easily be recognized.

In the above embodiment, a pattern whose luminance value gradually increases from the start point to the end point in a block is generated. Conversely, a pattern whose luminance value gradually decreases may be generated.

In this embodiment, the region in the block is divided into five regions. However, the code vector is divided into five regions only as an example, and the number of regions need not always be five.

(Third Embodiment)

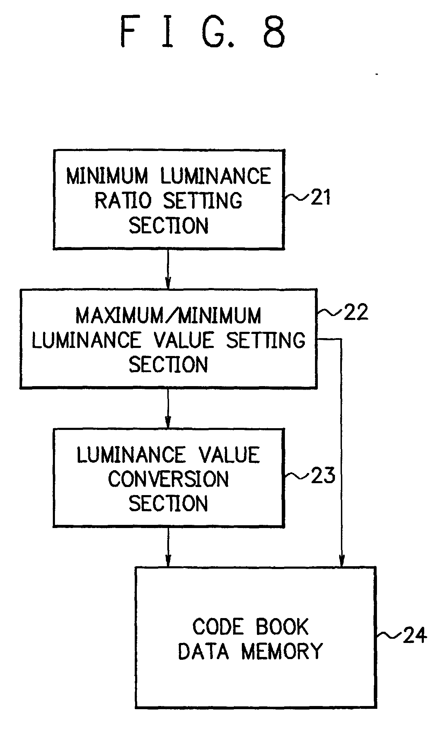

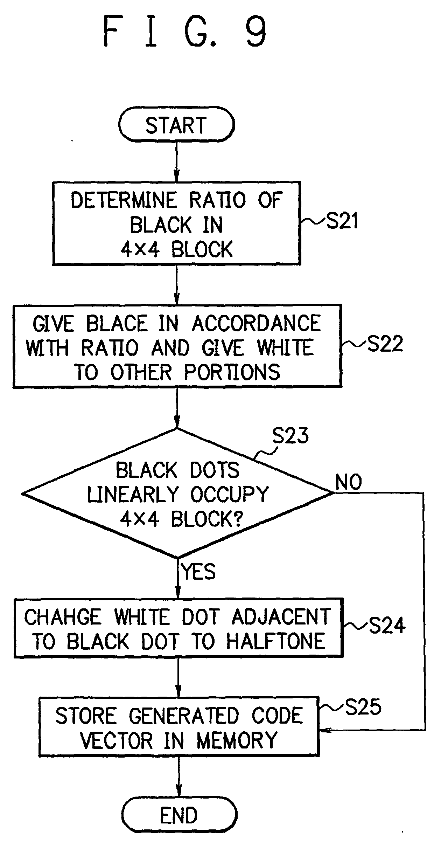

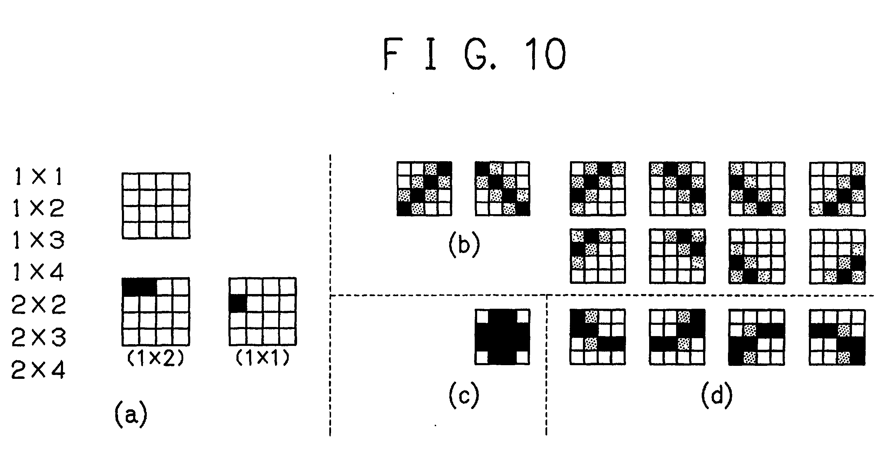

In the third embodiment, an apparatus and method for making a code book for, e.g., an image including a character will be described. Fig. 8 is a function block diagram showing the construction of the apparatus for making the code book according to this embodiment. Fig. 9 is a flow chart showing the operation of the apparatus for making the code book according to this embodiment. Fig. 10 shows conceptional views for explaining the method of making the code book for a character image according to this embodiment.

When an image including a character was checked, most patterns had large changes. In addition, most patterns fully used the dynamic range of luminance values of 256 levels. In this embodiment, the vectors of four typical patterns as shown in Fig. 10 are generated as code vectors for a character image.

The first patterns are patterns each obtained by appropriately embedding one of black patterns of seven types (patterns of minimum luminance values) of $1 \times 1$, $1 \times 2$, $1 \times 3$, $1 \times 4$, $2 \times 2$, $2 \times 3$, and $2 \times 4$ in a background white pattern (pattern of maximum luminance value) of 4 pixels $\times$ 4 pixels, as shown in Fig. 10(a). The second patterns are patterns each obtained by obliquely embedding black dots in a block, as shown in Fig. 10(b).

The third pattern is a pattern obtained by embedding black dots in a cross, as shown in Fig. 10(c). The forth patterns are patterns each obtained by embedding a line of black dots while bending it midway, as shown in Fig. 10(d). In these patterns, a pixel value adjacent to a black dot is set to an intermediate value in accordance with whether the black dots linearly occupy the block.

The function/construction and operation of the apparatus for generating code vectors as shown in Fig. 10 will be described next with reference to the block diagram shown in Fig. 8 and the flow chart shown in Fig. 9.

Referring to Fig. 9, first, in step S21, the ratio of pixels of black dots (minimum luminance value) in, e.g., a 4 $\times$ 4 pixel block is determined.

The black dot ratio in the block is performed by a minimum luminance ratio setting section 21 shown in Fig. 8. Note that the minimum luminance ratio setting section 21 can be constructed by an input device such as a keyboard or a mouse to cause the user to set an arbitrary ratio. Alternatively, the apparatus may automatically set the ratio in order sequentially to generate various patterns.

In step S22, black dots (minimum luminance value) are given to predetermined pixel positions in the block and white dots (maximum luminance value) are given to the other pixel positions using a maximum/minimum luminance value setting section 22 shown in Fig. 8 in accordance with the set black dot ratio. In step S23, it is determined whether the black dots linearly occupy the block. If NO in step S23, the code vector generated in processing until step S22 is stored in a code book data memory 24 shown in Fig. 8.

If YES in step S23, the flow advances to step S24 to change the luminance value of the pixel of a white dot adjacent to the pixel of a black dot to the halftone luminance value. The code vector generated in this way is stored in the code book data memory 24 shown in Fig. 8.

As described above, when one cycle of processing shown in the flow chart of Fig. 9 is ended, one code vector is generated and stored in the code book data memory 24. When such processing is executed two or more times while changing the black dot ratio in the block and the position to which the black dot is given in various ways, code vectors of various patterns are generated. The set of the code vectors is a code book for a character image.

Although not illustrated here, when the code book made in this embodiment was applied to character images of several types, as in the first embodiment, a PSNR characteristic almost the same as that of a code book optimally made by the Kohonen algorithm for each landscape image was obtained, and a relatively satisfactory PSNR characteristic was obtained.

As described above, according to the third embodiment, a greatly versatile code book compatible to various character images with only one code book can be obtained. Additionally, in this embodiment, since each code vector is generated in accordance with a predetermined rule, which pattern is included in the made code book can easily be recognized.

In the above embodiment, seven types of patterns $1 \times 1$, $1 \times 2$, $1 \times 3$, $1 \times 4$, $2 \times 2$, $2 \times 3$, and $2 \times 4$ are used as the black dot pattern in the block. However, the number of types need not always be seven.

(Fourth Embodiment)

In the fourth embodiment, the code books made by the methods described in the first to third embodiments are combined into one code book having a size of 1,024.

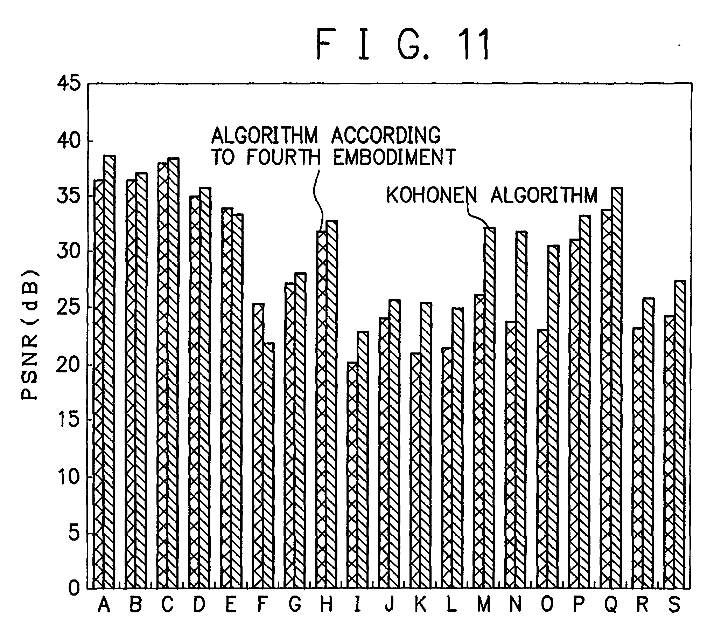

Fig. 11 is a graph showing the PSNR characteristics of images, which are obtained when vector quantization (VQ) processing is performed for images A to S of 19 types, including face images, landscape images, and character images, using the code book having a size of 1,024 according to this embodiment and then, each image is reconstructed using the same code book as that used for VQ. Fig. 11 also shows, as a reference, the PSNR characteristics of the images, which are obtained when the code book is individually optimized using the images by the Kohonen self-organizing map method, VQ processing is executed for each image using a corresponding code book, and then each image is reconstructed using the same code book as that used for VQ.

As is apparent from the result shown in Fig. 11, the PSNR characteristic obtained in use of one code book made by the method of this embodiment is equivalent to that obtained in use of the 19 code books made by the Kohonen algorithm. As described above, according to this embodiment, even one code book can provide almost the same PSNR characteristic as that obtained when optimum code books are made by the Kohonen algorithm for the respective images, and high-quality images can be reconstructed for various images including an image which monotonically changes or an image which abruptly changes, so a greatly versatile code book can be made.

In this embodiment, the size of the code book is set to 1,024. However, the size need not always be 1,024 and can be appropriately determined to, e.g., 128 or 512 in accordance with the application purpose. In addition, although code books of three types are combined into one code book, code books of appropriate two types may be combined into one code book.

In the above-described first to fourth embodiments, a code vector of 4 pixels $\times$ 4 pixels is generated. However, the code vector need not always have 4 pixels $\times$ 4 pixels, and the target of vector quantization need not always be image data.

The above-described code book making apparatus of this embodiment is constructed by a microcomputer system having a CPU, a ROM, and a RAM, and its operation is realized in accordance with an operation program stored in the ROM or RAM. In this case, a program for realizing the function of each function block of the code book making apparatus may be externally supplied to the computer through a recording medium to make the function block operate in accordance with the program.

In this case, as a recording medium which stores the program, for example, a floppy disk, a hard disk, an optical disk, an optical magnetic disk, a CD-ROM, a CD-I, a CD-R, a CD-RW, a DVD, a zip, a magnetic tape, or a nonvolatile memory card can be used.

The program is incorporated in the embodiments of the present invention not only when the functions of the above-described embodiments are realized when the computer executes the supplied program but also when the functions of the above-described embodiments are realized by the program cooperating with the OS (Operating System) or another application software running on the computer, or the functions of the above-described embodiments are realized when part or all of the processing of the supplied program is executed by the function expansion board or function expansion unit of the computer.

(Fifth Embodiment)

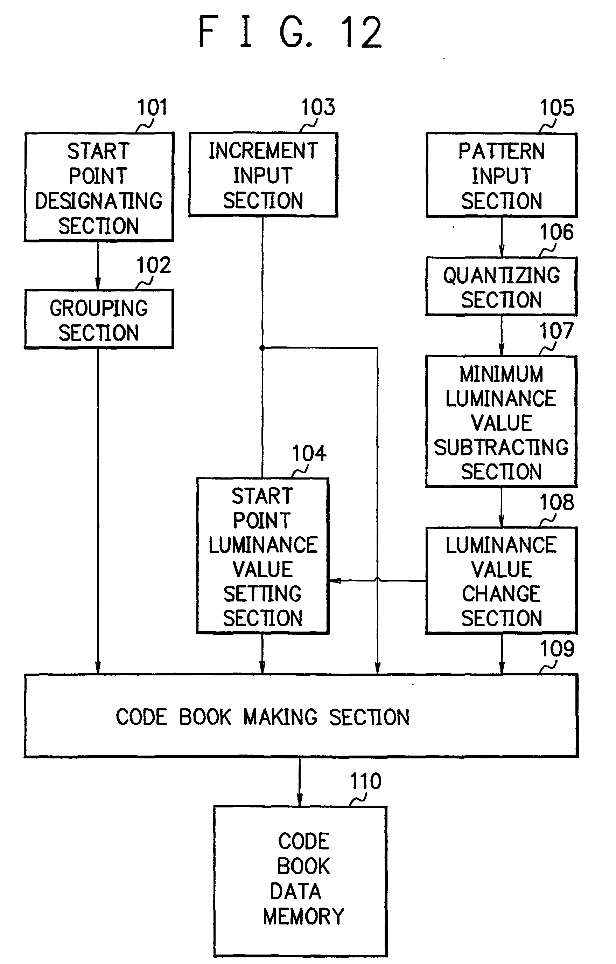

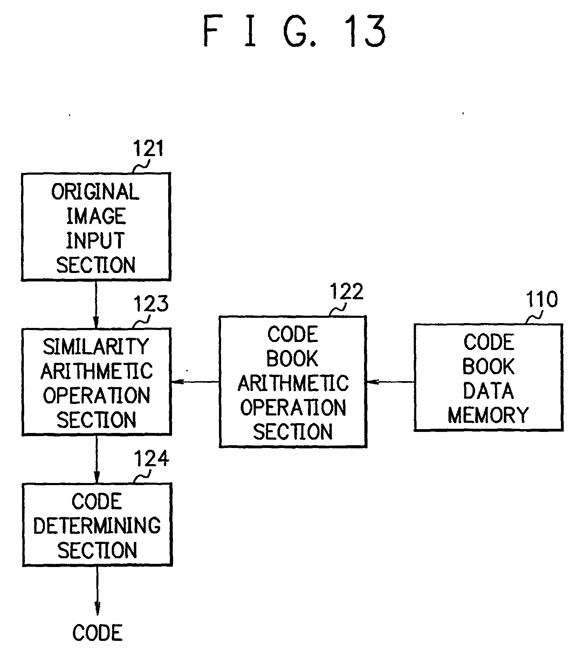

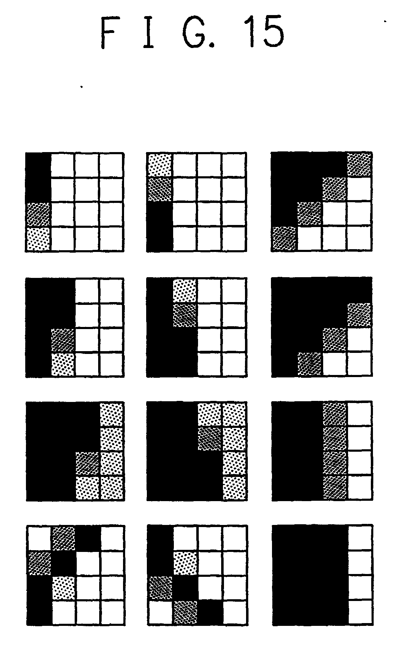

Fig. 12 is a function block diagram showing the construction of an apparatus for making a code book according to the fifth embodiment. Fig. 13 is a function block diagram showing the construction of a vector quantizing device for executing data compression using the made code book. Figs. 14 and 15 are illustrations showing examples of made code vectors (pattern images).

Generally, most parts of a face image are occupied by patterns whose pixel values smoothly change as a whole. The change is monotonic and very little. In a landscape image as well, patterns whose pixel values smoothly change as a whole are partially present. On the other hand, in a character or the like, generally, pixel values abruptly change, and the change is very great. Even a landscape image has a portion where the pixel values abruptly change, like a character.

As described above, all images which belong to various categories are roughly constructed by a pattern (to be referred to as a "solid pattern" hereinafter) where pixel values smoothly change as a whole and a pattern (to be referred to as an "edge pattern" hereinafter) where pixel values abruptly change. In this embodiment, taking this characteristic of an image into consideration, a code for a solid pattern and a code for an edge pattern are generated. When the codes for the two patterns are appropriately combined, they can cope with various images.

As codes for solid patterns, for example, patterns which monotonically change in eight directions are generated, as shown in Fig. 14. More specifically, a pattern whose pixel value (e.g., luminance value) gradually changes from one of the edge portions (upper, lower, left, and right sides and four corner points) of a 4 × 4 pixel block is generated. In this case, a 4 × 4 pixel code vector is generated as an example. However, the present invention is not limited to this size.

Referring to Fig. 14, (a) shows a pattern whose luminance value gradually increases, as A → B → C → D, from the left side to the right side of the block in units of vertical lines, (b) shows a pattern whose luminance value gradually increases from the right side to the left side of the block in units of vertical lines, (c) shows a pattern whose luminance value gradually increases from the lower side to the upper side of the block in units of horizontal lines, and (d) shows a pattern whose luminance value gradually increases from the upper side to the lower side of the block in units of horizontal lines.

(e) shows a pattern whose luminance value gradually increases from the upper left corner to the lower right corner of the block in units of oblique lines, (f) shows a pattern whose luminance value gradually increases from the upper right corner to the lower left corner of the block in units of oblique lines, (g) shows a pattern whose luminance value gradually increases from the lower left corner to the upper right corner of the block in units of oblique lines, and (h) shows a pattern whose luminance value gradually increases from the lower right corner to the upper left corner of the block in units of oblique lines.

Of these patterns of eight types shown in Fig. 14, one of the patterns shown in Figs. 14(a) to 14(d) and one of the patterns shown in Figs. 14(e) to 14(h), i.e. a total of two types are generated and registered in advance before actual execution of vector quantization. The remaining patterns of six types are generated in actually executing vector quantization, as will be described later. Assume that the patterns (to be referred to as "basic patterns" hereinafter) shown in Figs. 14(a) and 14(e) are generated in advance for the descriptive convenience.

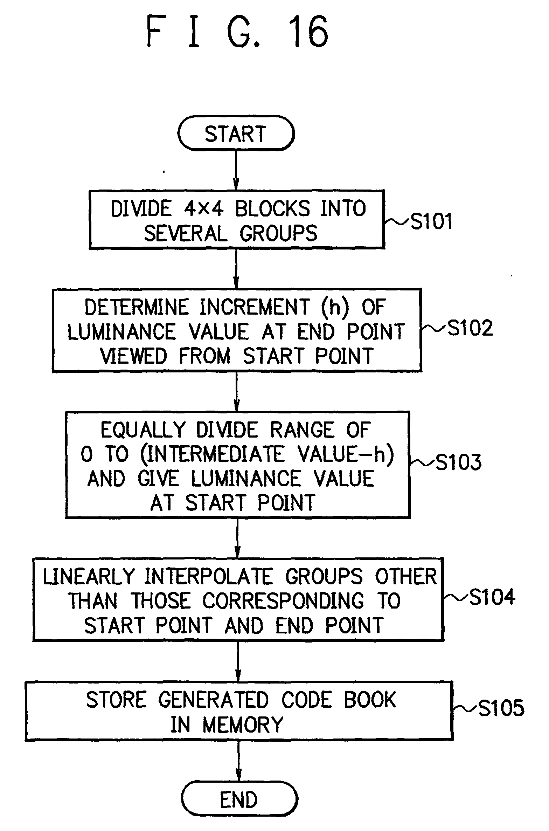

The procedure of generating the basic solid pattern will be described with reference to the code book making apparatus shown in Fig. 12 and the flow chart shown in Fig. 16.

Referring to Fig. 16, first in step S101, for example, a 4 × 4 pixel block is classified into several groups. For, e.g., the basic pattern shown in Fig. 14(a), the block is divided into four groups A to D in units of vertical lines.

In performing this grouping, first, the user designates a start point in the block using a start point designating section 101 shown in Fig. 12. To register the pattern shown in Fig. 14(a) as a basic pattern, the four pixels (group A) at the left side in the block are designated as a start point. Note that the start point designating section 101 is constructed by an input device such as a keyboard or a mouse.

A grouping section 102 performs grouping in accordance with the start point designated by the start point designating section 101. For example, to generate the pattern shown in Fig. 14(a) or 14(b) as a basic pattern, grouping is performed in units of lines in the vertical direction, or to generate the pattern shown in Fig. 14(c) or 14(d) as a basic pattern, grouping is performed in units of lines in the horizontal direction. To generate the patterns shown in Figs. 14(e) to 14(h) as basic patterns, grouping is performed in units of lines in the oblique directions.

As described above, when one of the patterns shown in Figs. 14(a) to 14(d) and one of the patterns shown in Figs. 14(e) to 14(h) are registered as basic patterns, all the remaining patterns are generated by arithmetic operation. Hence, for example, the basic patterns can always be fixed to the patterns shown in Figs. 14(a) and 14(e). In this case, the start point designating section 101 is unnecessary.

Next in step S102, the user inputs at least one increment h of the luminance value at the end point when viewed from the start point in the block using an increment input section 103 shown in Fig. 12. The increment input section 103 is also constructed by an input device such as a keyboard or mouse. Instead of inputting the increment h by the user, the apparatus may set a predetermined default value.

In step S103, a start point luminance value setting section 104 shown in Fig. 12 sets the luminance value at the start point in the block. To give the luminance value at the start point, for example, the range of

0 to (intermediate value of the possible range of luminance values - increment h)

is equally divided into n parts, and each equally divided value is set as the luminance value at the start point. Although the equally divided value is given here, it need not always be the equally divided value as far as it falls within the range of 0 to (intermediate value of the possible range of luminance values - increment h). In addition, although luminance values are given here by arithmetic operation, the user may arbitrarily input the luminance value at the start point within the above range by his/her discretion.

When necessary pieces of information including the increment h and the luminance value at the start point, are set, in step S104, a code book making section 109 shown in Fig. 12 executes arithmetic operation of, e.g., linear interpolation on the basis of the luminance value at the start point and the increment h of luminance value, thereby calculating the luminance value of each group. Thus, the code of a pattern whose luminance value gradually increases from the start point to the end point in units of groups is generated.

In this embodiment, since the luminance value at the start point is given by processing in step S103, all luminance values belonging to each group in the block are smaller than the intermediate value of the possible range of luminance values. That is, the code of the basic solid pattern generated here is a relatively dark image whose luminance value as a whole is smaller than the intermediate value.

In step S102, at least one increment h is given, and in step S103, luminance values at the start point are given on the basis of the value of each increment h. Hence, codes are generated for the basic pattern shown in Fig. 14(a) on the basis of different luminance values. One increment h and one luminance value at the start point may be given to generate only one basic pattern.

The codes (code vectors) generated in the above way are stored in a code book data memory 110 as a basic solid pattern code book in step S105.

In this example, a pattern whose luminance value gradually increases from the start point to the end point in a block is generated. Conversely, a pattern whose luminance value gradually decreases may be generated.

On the other hand, as the codes of basic patterns related to edges, for example, patterns of 12 types as shown in Fig. 15 are generated as patterns whose luminance values abruptly change. In all edge patterns generated here, the edge portion is present on at least one of the four pixels constituting the left side in the block. Although the basic patterns of 12 types are shown, the number of types is not limited to 12.

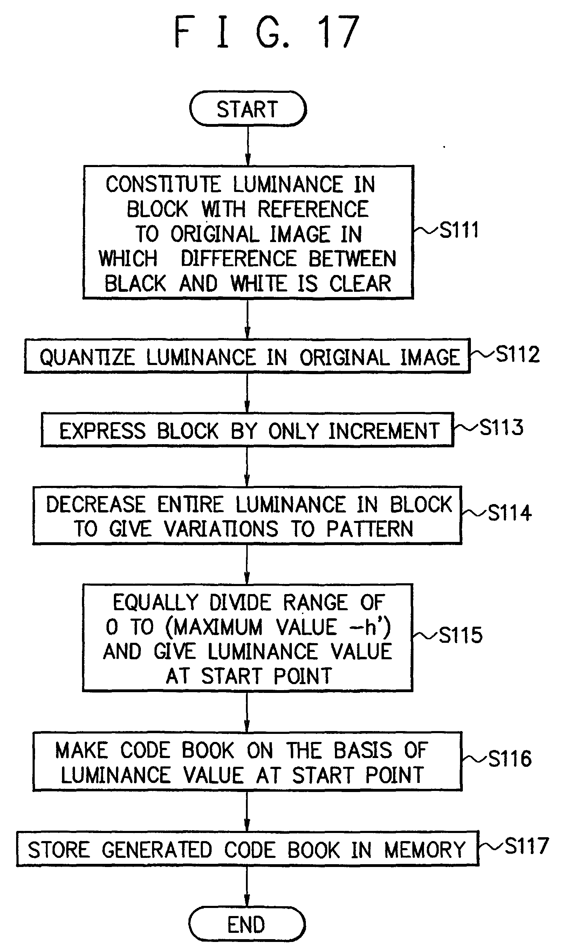

The procedure of generating a basic edge pattern will be described with reference to the code book making apparatus shown in Fig. 12 and the flow chart shown in Fig. 17.

Referring to Fig. 17, first in step S111, several reference patterns which should be employed as edge patterns are input using a pattern input section 105 shown in Fig. 12. In this case, with reference to, e.g., a block in the original image, which is present at an edge where the difference between black and white is clear, the luminance structure is input as the luminance structure of an edge pattern.

When several (12 in the example shown in Fig. 15) patterns are input from the original image, in step S112, a quantizing section 106 quantizes the luminance value of each pixel in the blocks constituting the patterns, thereby expressing the luminance values in the blocks using only predetermined values.

In step S113, for each input and quantized pattern, a minimum luminance value subtracting section 107 subtracts the minimum luminance value in each block from the luminance values of all pixels in the block. Thus, the luminance value of each pixel in the block is expressed by only an increment value (difference value) with respect to the minimum luminance value. In step S114, a luminance value change section 108 also generates patterns in which the luminance value of each pixel in the block is changed to make variations of the edge pattern to be registered.

For example, the luminance values of all pixels in the block of the pattern generated by the minimum luminance value subtracting section 107 are equally divided into m parts, and each equally divided value is set as the luminance value of each pixel, thereby increasing the number of patterns to m. When this processing is ended, the difference between the minimum luminance value (it is set to 0 in step S113) and the maximum luminance value in the block, i.e., an increment h' is known.

Next, in step S115, the start point luminance value setting section 104 shown in Fig. 12 sets the luminance value (minimum luminance value) at the start point in the block. To give the luminance value at the start point, for example, the range of

0 to (maximum value of the possible range of luminance values - increment h')

is equally divided into k parts, and each equally divided value is set as the luminance value at the start point. In this case as well, the value need not always be an equally divided value, as in step S103 shown in Fig. 16. In addition, the user may arbitrarily input a luminance value within the above range by his/her discretion.

When necessary pieces of information including the luminance value at the start point, are set, in step S116, the code book making section 109 shown in Fig. 12 calculates the luminance value of each pixel in the block on the basis of the luminance value at the start point and the luminance value of each pixel of the patterns generated in step S114. Thus, codes of edge patterns whose luminance values abruptly change are generated. The codes (code vectors) generated in the above way are stored in the code book data memory 110 as a basic edge pattern code book in step S117.

An construction and operation of actually executing vector quantization using the basic pattern code books made in the above way and stored in the code book data memory 110 will be described next.

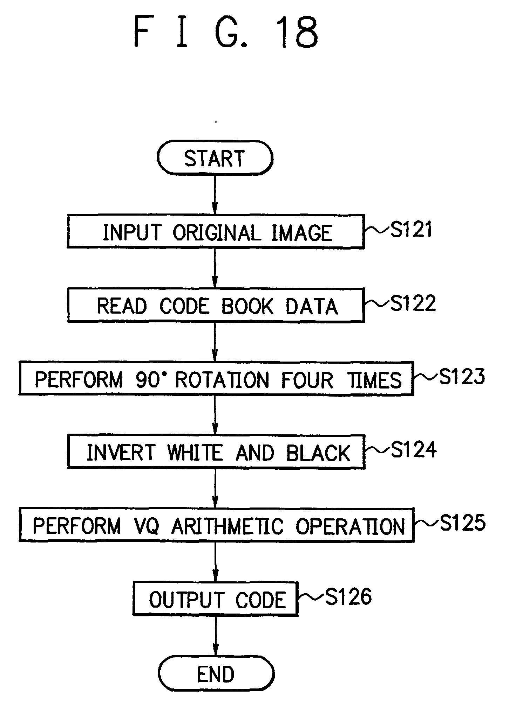

Fig. 13 is a function block diagram showing the schematic construction of a vector quantizing device according to this embodiment. Fig. 18 is a flow chart showing the operation of this vector quantizing device.

First in step S121 shown in Fig. 18, an original image input section 121 inputs arbitrary image data as a compression target. In step S122, a code book arithmetic operation section 122 reads out the basic pattern code books stored in the code book data memory 110. In this case, all basic patterns of the solid patterns and edge patterns are read.

In step S123, the code book arithmetic operation section 122 that has read the basic patterns rotates each read basic pattern through 90° four times, thereby generating the codes of different patterns from the basic pattern. For example, when the patterns shown in Figs. 14(a) and 14(e) are registered as the basic patterns of solid patterns, the patterns shown in Figs. 14(b) to 14(d) and Figs. 14(f) to 14(h) are generated by this processing. For the edge patterns as well, the basic patterns of 12 types shown in Fig. 15 are rotated to generate different patterns from these basic patterns. The number of patterns of codes increases to four times.

In step S124, the code book arithmetic operation section 122 also executes, for each pattern obtained in step S123, processing of inverting the white and black portions (processing of folding back the luminance value with respect to the intermediate value), thereby further generating codes of different patterns.

With such rotation processing and white/black inversion processing, even when the number of patterns registered in the code book data memory 110 is relatively small, the number of patterns actually used in vector quantization becomes very large, so a pattern greatly similar to the original image is present at a very high possibility.

For a solid pattern, the patterns obtained by rotation processing will not be the same. In addition, since a basic solid pattern generated in advance is a relatively dark pattern whose luminance values of all pixels are smaller than the intermediate value, the patterns obtained by white/black inversion processing are relatively bright patterns whose luminance values of all pixels are larger than the intermediate value. Hence, in this case as well, the patterns obtained by rotation processing will not be the same.

For an edge pattern, in inputting the reference pattern with reference to the original image at the first stage, the pattern is input assuming whether the same patterns are to be generated by rotation processing or white/black inversion processing. However, this operation is not always easy. Such disadvantage can be avoided by, e.g., providing, in the code book making apparatus shown in Fig. 12, an arithmetic operation section for executing rotation processing or white/black inversion processing, and when comparison between the arithmetic operation result with the original data reveals the same patterns, outputting an error.

In step S125 shown in Fig. 18, arithmetic operation of vector quantization (VQ) is executed on the basis of the original image data input in step S121 and the code data generated by the code book arithmetic operation section 122. More specifically, first, using the original image data and code data, a similarity arithmetic operation section 123 shown in Fig. 13 calculates the similarity therebetween in units of blocks.

The similarity is a numerical value which is obtained by inputting, to a certain function, vector data constituted by pixel values in a block extracted from original image data and vector data constituted by pixel values in the block of code vector and represents the degree of similarity therebetween. A representative example of such a function is a function for obtaining the Manhattan distance (absolute difference value distance) or Euclidean distance between two input vector data.

A code determining section 124 determines, in units of blocks, a code vector having the largest similarity (the smallest Manhattan distance or Euclidean distance) for the code vectors generated by the code book arithmetic operation section 122. In step S126, a code corresponding to the determined code vector is applied to the block, thereby outputting compressed data.

As described above in detail, according to this embodiment, in consideration of the fact that images of all types are constituted by combinations of solid patterns and edge patterns, the codes of solid patterns and the codes of edge patterns are generated in advance. At this time, as shown in Figs. 16 and 17, on the basis of the input reference information, basic patterns are standardized and generated according to a predetermined processing procedure.

Hence, when thus generated solid pattern codes and edge pattern codes are used, and data compression is executed for various data including data whose luminance value monotonically changes and data whose luminance value abruptly changes, the quality of the image reconstructed from the compressed data can be improved. That is, according to this embodiment, a greatly versatile code book capable of obtaining high-quality reconstructed images for various images can be realized.

In this embodiment, when actual vector quantization is executed using the above-described code books, codes of different variations are generated by rotation processing or white/black inversion processing. For this reason, the code of a pattern closer to the original image can be applied, and the quality of the reconstructed image can be further improved. In this case, these generated codes need not be stored in the code book data memory 110 in advance either, the capacity of the code book data memory 110 can be suppressed.

In the above embodiment, the basic pattern code books are made in advance and stored in the code book data memory 110. However, only pieces of information (e.g., information including the position of the start point, start point luminance value, the increment from the start point to the end point) as a reference for basic pattern generation may be stored, and the codes of various patterns, including the basic patterns, may be generated in actually executing vector quantization. In this case, the memory capacity can be made smaller.

In the above embodiment, rotation processing and white/black inversion processing are performed in executing vector quantization. However, these processes may be performed in advance before execution of vector quantization and stored in the code book data memory 110. In this case, although the capacity of the code book data memory 110 becomes large, the advantage that a versatile code book can be provided is obtained. In addition, since the arithmetic operation amount in executing vector quantization can be reduced, the processing speed becomes high.

In the above embodiment, to increase the number of patterns of usable code vectors, equally divided values are employed as luminance values at the start point in step S103 shown in Fig. 16 and step S115 shown in Fig. 17. However, in order to suppress the capacity of the code book data memory 110 as small as possible, only one luminance value may be employed within the above-described range.

Processing in steps S113 to S116 shown in Fig. 17 is also done to increase the number of patterns of usable code vectors. Hence, as described above, in order to suppress the capacity of the code book data memory 110 as small as possible, these steps may be omitted, and only processing of standardizing the pixel values may be performed in step S112.

However, processing as in the above embodiment is preferably executed not only to reduce the capacity of the code book data memory 110 as small as possible but also to improve the quality of the reconstructed image as much as possible.

In the above embodiment, both rotation processing and white/black inversion processing are performed. However, only one of them may be executed.

In the above embodiment, in calculating similarity by the similarity arithmetic operation section 123, a code vector is rotated or inverted by the code book arithmetic operation section 122. Conversely, the original image may be rotated or inverted to calculate the similarity without processing the code vector.

In the above embodiment, in generating a basic solid pattern, a pattern which is relatively dark as a whole is generated. Conversely, a relatively bright pattern may be generated.

Each of the function blocks shown in Figs. 12 and 13 is constructed by, e.g., a microcomputer system comprising a CPU or an MPU, a ROM, and a RAM such that its operation can be realized in accordance with an operation program stored in the ROM or RAM, or constructed by hardware. In this case, although Figs. 12 and 13 are independently illustrated, these constructions may be combined to form one vector quantizing device.

Additionally, an operation program code for realizing the function of each function block may be supplied from an external recording medium to the computer, and each function block may be operated in accordance with the program. In this case, as a recording medium which stores the program, for example, a floppy disk, a hard disk, an optical disk, an optical magnetic disk, a CD-ROM, a CD-I, a CD-R, a CD-RW, a DVD, a zip, a magnetic tape, or a nonvolatile memory card can be used.

(Sixth Embodiment)

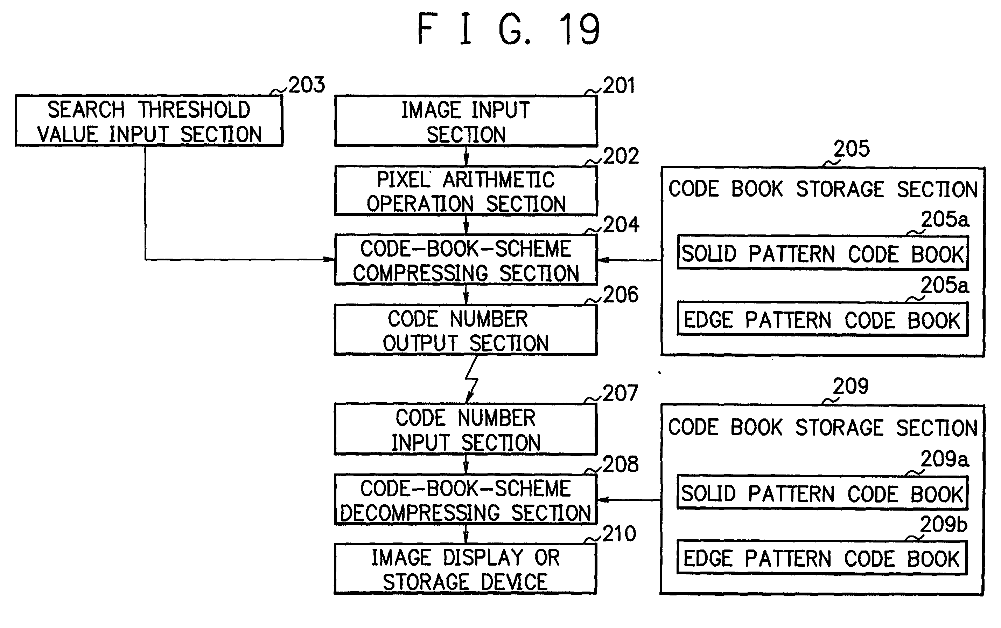

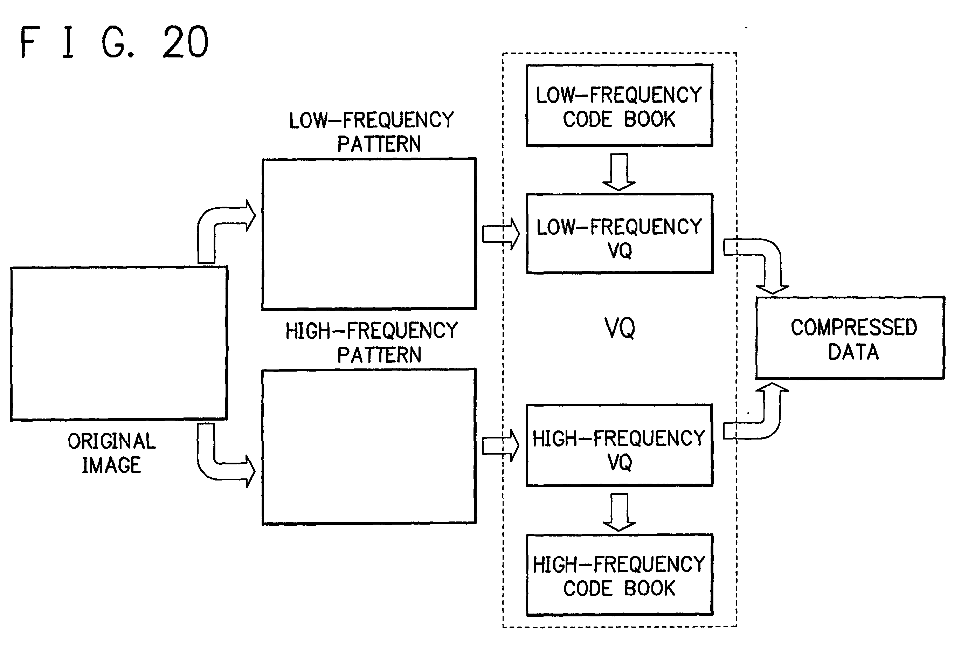

Fig. 19 is a block diagram showing a construction of a system for data compression/decompression according to the sixth embodiment. Fig. 20 is an illustration for explaining the operation principle of the operation according to this embodiment. The principle will be described first with reference to Fig. 20.

As shown in Fig. 20, in this embodiment, blocks (for example, one block has $4 \times 4$ pixels) extracted from an original image in executing vector quantization are classified into blocks (to be referred to as low-frequency patterns or solid patterns hereinafter) each having pixel values gradually changing in a predetermined direction in the block and blocks (to be referred to as high-frequency patterns or edge patterns hereinafter) each having pixel values abruptly changing in the block.

Vector quantization (VQ) processing is independently performed for the blocks of solid patterns and edge patterns using a low-frequency code book and high-frequency code book, which are prepared in advance for the respective patterns, and results obtained for the respective patterns are combined to obtain compressed data. Although individual blocks are not illustrated in Fig. 20, only the blocks of solid patterns are included in the image of the low-frequency pattern, and only the blocks of edge patterns are included in the image of the high-frequency pattern.

Fig. 19 shows a construction for realizing such operation.

Referring to Fig. 19, an image input section 201 inputs image data as a compression target. This image input section 201 has a function of segmenting the entire input image into blocks each formed from, e.g., 4 × 4 pixels and outputting an image in units of blocks. The image data as a compression target can be either a still image or a moving picture. The image data can be either a monochromatic image or a color image.

A pixel arithmetic operation section 202 executes arithmetic operation necessary to determine whether an input block image corresponds to a solid pattern or edge pattern. For example, the minimum luminance value and maximum luminance value are detected from pixels in the block, and the difference therebetween is calculated. When this difference is small, the image corresponds to a solid pattern whose luminance value gradually changes. When the difference is large, the image corresponds to an edge pattern whose luminance value abruptly changes.

A search threshold value input section 203 inputs a threshold value necessary for pattern determination based on the difference between the minimum luminance value and the maximum luminance value in the block, which is calculated by the pixel arithmetic operation section 202. A code-book-scheme compressing section 204 determines whether the block is a solid pattern or edge pattern on the basis of the arithmetic operation result received from the pixel arithmetic operation section 202 and the threshold value received from the search threshold value input section 203, and executes vector quantization processing using an appropriate code book according to the pattern.

More specifically, when the block is a solid pattern, vector quantization is executed using a solid pattern code book 205a stored in a code book storage section 205 in advance. On the other hand, when the block is an edge pattern, vector quantization is executed using an edge pattern code book 205b stored in the code book storage section 205 in advance. The code book storage section 205 stores in advance as code vectors pixel patterns each having the same size (4 × 4 pixel block) as that of the block extracted from the original image.

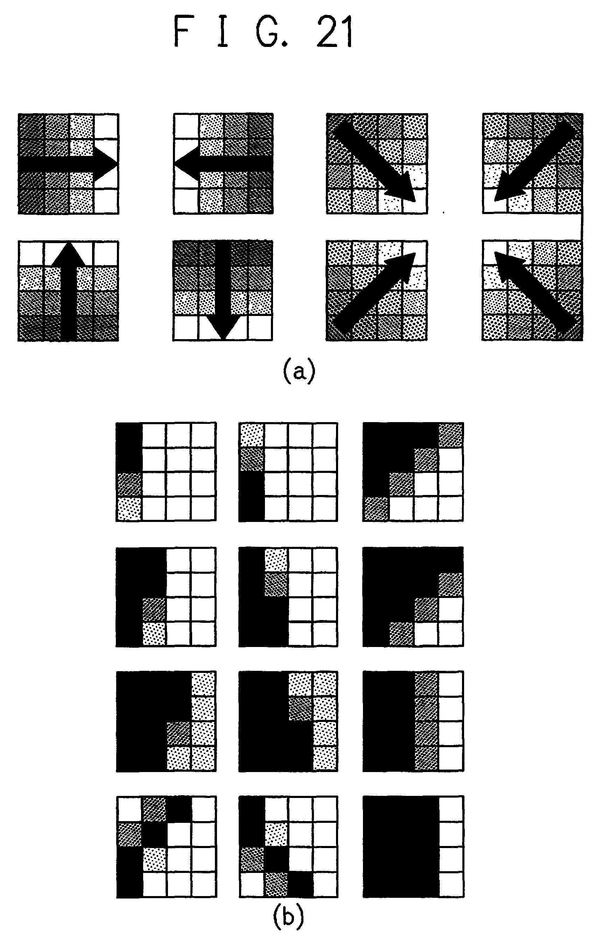

In the solid pattern code book 205a, code vectors of patterns which monotonically change in eight directions are registered, as shown in Fig. 21(a). More specifically, a set of patterns each having a pixel value (e.g., luminance value) gradually changing from as the start point one of the edge portions (upper, lower, left, and right sides and four corner points) of a block formed from 4 × 4 pixels is registered. Although only eight patterns are illustrated, a number of solid patterns are actually registered with variations in luminance value at the start point or degree of change in luminance.

In the edge pattern code book 205b, code vectors of patterns each having a luminance value abruptly changing are registered, as shown in Fig. 21(b). Although only 12 patterns are illustrated, a number of edge patterns are actually registered with variations or including patterns other than those illustrated here.

Referring back to Fig. 19, a code number output section 206 outputs a code number string obtained as a result of vector quantization executed by the code-book-scheme compressing section 204 in units of blocks. In this embodiment, the code vectors constituting the solid pattern code book 205a and edge pattern code book 205b are assigned a series of code numbers (addresses of a storage device or the like), and a code number string corresponding to code vectors searched as code vectors having large similarities is output in units of blocks. The construction on the compressing side has been described above.

A code number input section 207 receives the code number string of blocks output from the code number output section 206 on the compressing side. The code number output section 206 and code number input section 207 can be connected through a communication path such as a network such that a code number is transferred through this network. Alternatively, the code number string output from the code number output section 206 may be temporarily stored in a storage medium such as a floppy disk and input to the decompressing side through the storage medium.

A code-book-scheme decompressing section 208 executes processing of reading out, from a code book storage section 209, the pattern images of code vectors corresponding to the code number sequence received from the code number input section 207 and embedding the pattern images at corresponding block positions, thereby generating a reconstructed image. When an input code number corresponds to a solid pattern, a corresponding code vector is read out from a solid pattern code book 209a. When a code number corresponds to an edge pattern, a corresponding code vector is read out from an edge pattern code book 209b.

Like the code book storage section 205 on the compressing side, the code book storage section 209 stores in advance, as code vectors, pixel patterns each having the same size (4 × 4 pixel block) as the block extracted from the original image. As the code books, the code books on the compressing side can be transmitted and stored before decompression processing. Alternatively, identical code books may be stored from the beginning.

The reconstructed image generated by the code-book-scheme decompressing section 208 is supplied to an image display device or a storage device 210 and displayed as an image or stored as image data. The construction on the decompressing side has been described above.

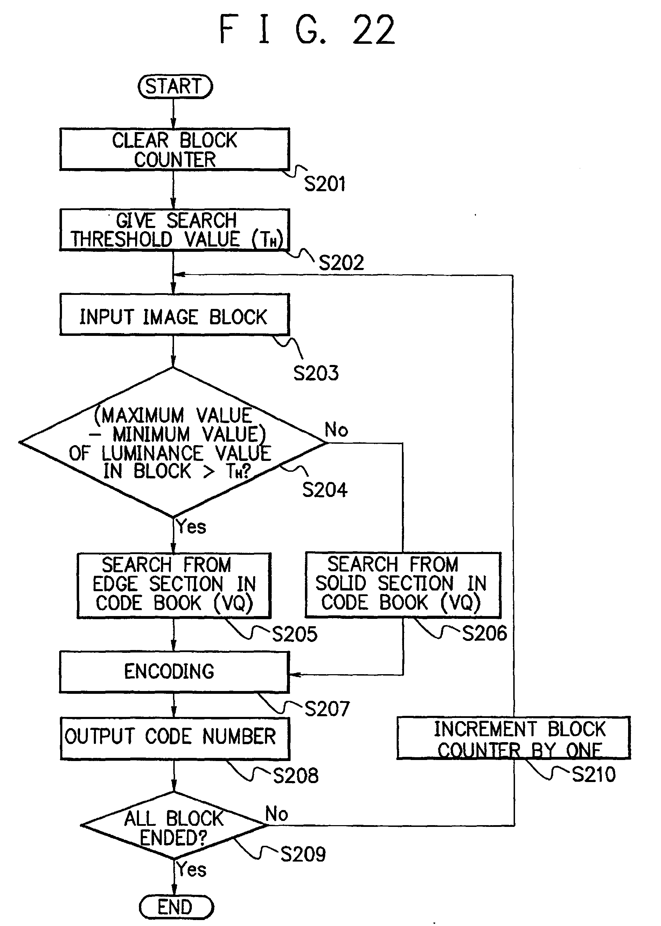

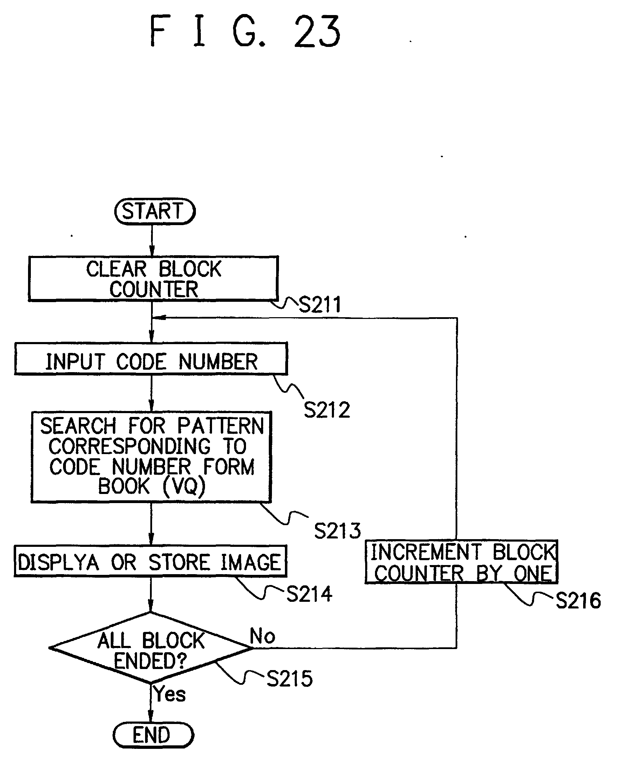

The detailed operation of the system for data compression/decompression according to this embodiment having the above construction will be described next with reference to the flow charts shown in Figs. 22 and 23.

Fig. 22 shows the operation on the compressing side. Referring to Fig. 22, first in step S201, processing processing is executed. In this case, processing of clearing the block counter for counting processed blocks is executed.

In step S202, a threshold value $T_H$ for search is given, and then in step S203, one image block is input. In step S204, for the input image block, the difference between the maximum luminance value and the minimum luminance value in the block is calculated, and it is determined whether the calculation result is larger than the search threshold value $T_H$.

If the calculated difference value is larger than the search threshold value $T_H$, the block is the image of an edge pattern. Hence, the flow advances to step S205 to execute vector quantization processing using the edge pattern code book 205b and search for the code vector of an edge pattern most similar to the input image block.

On the other hand, if the calculated difference value is not larger than the search threshold value $T_H$, the block is the image of a solid pattern. Hence, the flow advances to step S206 to execute vector quantization processing using the solid pattern code book 205a and search for the code vector of a solid pattern most similar to the input image block.

When vector quantization processing is ended in step S205 or S206, the flow advances to step S207, the image of the input block is replaced with a code number corresponding to the search code vector and encoded. After that, in step S208, the replaced code number is output.

The flow advances to step S209 to determine whether the above-described processing is ended for all blocks in the image. If NO in step S209, the value of the block counter is incremented by one in step S210, and the flow returns to step S203 to repeat the above processing. When optimum codes are obtained for all blocks in the image in the above way, the original image is compressed. Note that processing in step S208 can be replaced with that in step S209 to output the code number string of one image together.

Fig. 23 shows the operation on the decompressing side. Referring to Fig. 23, first in step S211, processing processing is executed. In this case, processing of clearing the block counter for counting processed blocks is executed. In step S212, a code number specified on the compressing side is input.

In step S213, on the basis of the input code number, the pattern image of a code vector corresponding to the code number is searched from the solid pattern code book 209a or edge pattern code book 209b. The pattern image is read out and embedded at a corresponding block position (more specifically, the pattern image is stored at a predetermined position of a reconstructed image buffer).

After the reconstructed image generated is display on a display or stored in a storage medium in step S214, the flow advances to step S215 to determine whether the above-described processing is ended for all blocks in the image. If NO in step S215, the value of the block counter is incremented by one in step S216, and then the flow returns to step S212 to repeat the above processing.

When pattern images are reconstructed for all blocks in the image, the original image is reconstructed. Note that processing in step S214 can be replaced with that in step S215 to execute image display or storage processing after one reconstructed image is entirely generated.

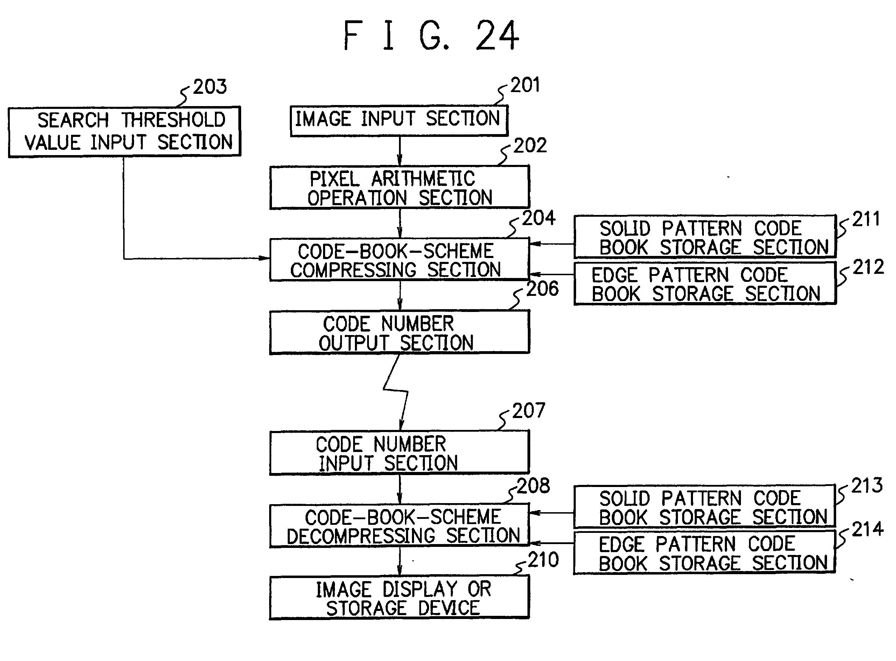

In the above example, the solid pattern section and edge pattern section are provided in one code book. However, as shown in Fig. 24, two code books, i.e., the code book for solid patterns and that for edge patterns may be separately prepared. More specifically, in this example, solid pattern code book storage sections 211 and 213 for storing code books for solid patterns and edge pattern code book storage sections 212 and 214 for storing code books for edge patterns are separately prepared.

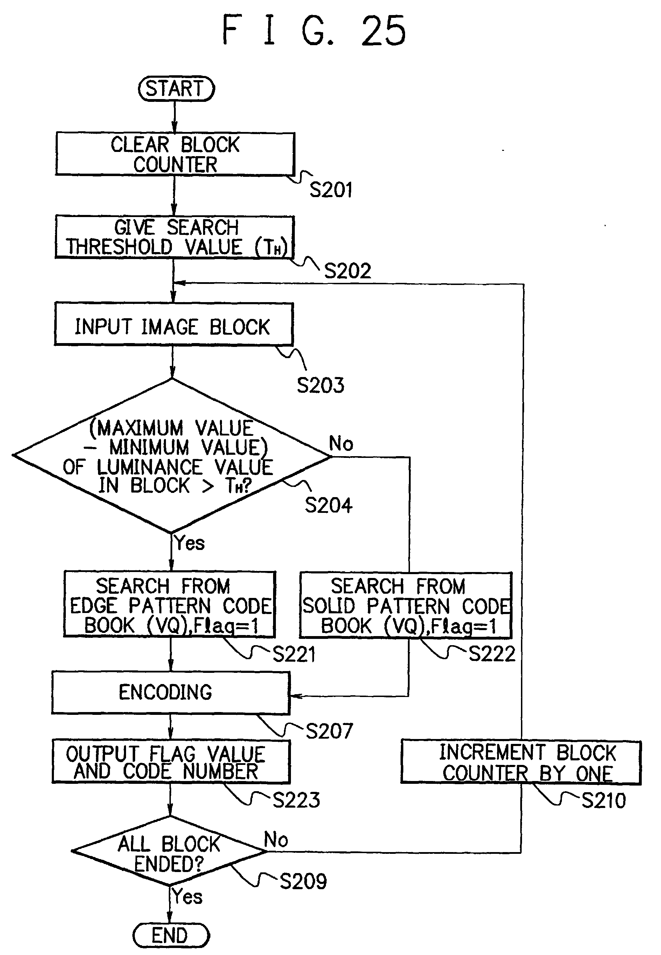

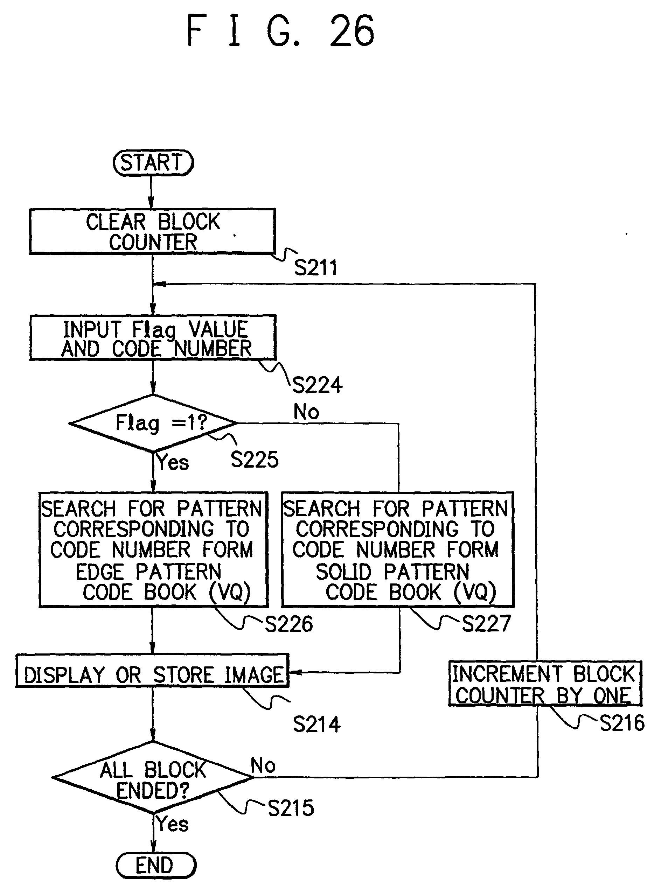

In this construction, since the code book storage sections are independently assigned code numbers (addresses or the like), a solid pattern and an edge pattern may be assigned a single code number. Hence, to identify an input code number corresponding to a solid pattern or edge pattern in decompression processing, flag information is transmitted together with a code number. Figs. 25 and 26 are flow charts showing this operation.

In the compressing-side operation shown in Fig. 25, the processes in steps S205, S206, and S208 shown in Fig. 22 are replaced with processes in step S221, S222, and S223, respectively. In step S221, when the difference value calculated between the maximum luminance value and the minimum luminance value in a block is larger than the search threshold value $T_H$, vector quantization processing is executed using the code book in the edge pattern code book storage section 212, and the flag is set to "1".

In step S222, when the calculated difference value is not larger than the search threshold value $T_H$, vector quantization processing is executed using the code book in the solid pattern code book storage section 211, and the flag is set to "0". In step S223, the flag information set in the above manner is output in addition to the replaced code number.

In the decompressing-side operation shown in Fig. 26, the process in step S212 shown in Fig. 23 is replaced with the process in step S224 and the processes in step S213 is replaced with the processes in step S225, S226, and S227. In step S224, the above flag information is input in addition to the code number specified on the compressing side. In step S225, it is determined whether the input flag is "1". If YES in step S225, the flow advances to step S226.

If NO in step S225, the flow advances to step S227.

In step S226, on the basis of the input code number, the pattern image of a code vector corresponding to the code number is read out from the edge pattern code book storage section 214 and embedded at a corresponding block position. In step S227, on the basis of the input code number, the pattern image of a code vector corresponding to the code number is read out from solid pattern code book storage section 213 and embedded at a corresponding block position.

The same reference numerals as in Fig. 19 denote the components having the same functions in Fig. 24, the same step numbers as in Figs. 22 and 23 denote the same processes in Figs. 25 and 26, and a detailed description thereof will be omitted.

As described above, in this embodiment, in executing vector quantization, instead of sequentially extracting blocks from one image and executing vector quantization using one code book, the luminance distribution in each block extracted from the original image is detected, and it is determined whether the block is a solid pattern or edge pattern of the image.

When the extracted block is a solid pattern, a code vector having large similarity is selected from the solid pattern section in the code book or an independently prepared solid pattern code book. When the extracted block is an edge pattern, a code vector having large similarity is selected from the edge pattern section in the code book or an independently prepared edge pattern code book.

As described above, in this embodiment, since a significance is given in constituting one image by blocks, and vector quantization is executed accordingly, an optimum pattern image can be selected for a solid pattern from a code book corresponding to solid patterns, and an optimum pattern image can be selected for an edge pattern from a code book corresponding to edge patterns. Hence, when an image is reconstructed using thus determined pattern images, a reconstructed image with higher quality can be obtained.

(Seventh Embodiment)

The seventh embodiment of the present invention will be described next. As has been described in the background art, in obtaining a natural reconstructed image matching the human visual characteristic especially for a solid pattern, the direction of change in luminance value of each pixel in a block acts as an important factor. For a solid pattern, the direction of luminance change can be predicted from the pixel values at the four corners in the block.

For example, a block shown in Fig. 27 is the block of a solid pattern in which the luminance value gradually increases from the upper right pixel to the lower left pixel in the block, or the luminance value gradually decreases from the lower left pixel to the upper right pixel. In this case, when the pixel values at the four corners are known, the direction of change in luminance value in the block can be known.

In the seventh embodiment, in obtaining similarity between the input vector of a block extracted from an original image and each code vector in a code book, arithmetic operation is performed for a solid pattern using only pieces of information on the pixels (four dimensions) at the four corners instead of arithmetic operation using pieces of information on all pixels (16 dimensions) in the block.

The construction for implementing a system for data compression/decompression according to the seventh embodiment is the same as that shown in Fig. 19 or 24. However, the contents of vector quantization processing executed by a code-book-scheme compressing section 204 are different from those of the sixth embodiment. The flow chart showing the operation is also almost the same as in the sixth embodiment except the contents of search processing in step S206 shown in Fig. 22 and in step S222 shown in Fig. 25.

More specifically, in the sixth embodiment, for example, the Manhattan distance or Euclidean distance is calculated using all the 16 pixels in a block, thereby obtaining similarity between two vectors. To the contrary, in the seventh embodiment, for a solid pattern, similarity such as the Manhattan distance is calculated using only pixels at the four corners, and simultaneously, the direction of luminance change in the block is detected. A code vector having large similarity to the input vector of the original image and having the same direction of luminance change as that of the input vector is selected from a code book.

With this construction, a disadvantage that an unnatural pattern image whose luminance in the block changes in a direction opposite to that in the entire, image is selected can be properly prevented, and a more natural pattern image according to the human visual characteristic can be properly selected. This makes it possible to obtain a reconstructed image having a higher quality. In addition, since arithmetic operation for only four dimensions suffices, the processing speed can be increased.

In the seventh embodiment, in executing vector quantization, only pieces of information on pixels at the four corners in a block are used for arithmetic operation, and pieces of information on the remaining pixels are not used. For this reason, each code vector in the code book may be constituted by only the four-dimensional information corresponding to the pixels at the four corners instead of constituting the code vector by 16-dimensional information as in the sixth embodiment. This reduces the storage capacity of the code book storage section. In addition, code vectors of a larger number of types can be registered without increasing the storage capacity, and the quality of a reconstructed image can be further improved.

In this case, however, the original image cannot be reconstructed using only the pixel information at the four corners in decompression processing. To do this, for example, for a solid pattern code book 205a in a code book storage section 205 shown in Fig. 19, each code vector is constituted using only the four-dimensional information, and for a solid pattern code book 209a in a code book storage section 209, each code vector is constituted using the 16-dimensional information.

Alternatively, for both the solid pattern code books 205a and 209a, each code vector may be constituted by only the four-dimensional information and pieces of information on pixels except the four corners may be generated from the pieces of information on the pixels at the four corners by arithmetic operation, e.g., linear interpolation. In this case, for example, an arithmetic operation section for calculating linear interpolation or the like is arranged on the output side of a code-book-scheme decompressing section 208 shown in Fig. 19.

For code vectors which have the same luminance values at the start and end points but different directions of luminance change or code vectors which have the same form of luminance change but different luminance values of pixels, only a representative code vector may be stored, and rotation arithmetic operation of a block of white/black inversion arithmetic operation of a luminance value (processing of folding back the luminance value with respect to the intermediate value) may be executed on the basis of the code vector to generate other code vectors.

In the above embodiments, the block size is set to $4 \times 4$ pixels. However, the present invention is not limited to this.

In the above embodiments, to discriminate between a solid pattern and an edge pattern, it is checked whether the difference between the maximum luminance value and the minimum luminance value in a block is larger than a predetermined threshold value. However, the present invention is not limited to this method as far as the two patterns can be discriminated.

In addition, blocks may be classified into different patterns using other information (e.g., color information), and vector quantization may be independently executed for the blocks.

The classified patterns are not limited to the above-described two types, and blocks may be classified into patterns of a larger number of types.

Each of the function blocks shown in Fig. 19 or 24 can be constructed by either hardware or a microcomputer system comprising a CPU or an MPU, a ROM, and a RAM in this embodiment such that its operation is realized in accordance with an operation program stored in the ROM or RAM. The present invention also incorporates a case wherein a software program for realizing the functions to realize the function of each function block is supplied to the RAM, and each function block is made to operate in accordance with the program.

In this case, the software program itself constitutes the functions of the above-described embodiments, and the program itself, and the means for supplying the program to the computer, and for example, a recording medium which stores the program constitutes the present invention. As a recording medium which stores the program, for example, not only the ROM or RAM but also a floppy disk, a hard disk, an optical disk, an optical magnetic disk, a CD-ROM, a CD-I, a CD-R, a CD-RW, a DVD, a zip, a magnetic tape, or a nonvolatile memory card can be used.

The program is incorporated in the embodiments of the present invention not only when the functions of the above-described embodiments are realized when the computer executes the supplied program but also when the functions of the above-described embodiments are realized by the program cooperating with the OS (Operating System) or another application software running on the computer.

The present invention also incorporates a case wherein the functions of the above-described embodiments are realized when the supplied program is stored in a memory provided in the function expansion board of the computer or the function expansion unit connected to the computer, and the CPU provided in the function expansion board or function expansion unit executes part or all of actual processing on the basis of instructions of the program.

Industrial Applicability

As has been described above, according to the present invention, by giving a desired value to the data of a code vector, a greatly versatile code book capable of coping with various data including data which monotonically varies or data which abruptly varies can be realized without increasing the memory capacity for storing it. When the code book made by the present invention is used, a greatly versatile system for data compression/decompression, which can reconstruct high-quality images for various images even at a high compression ratio can be implemented.

According to the present invention, in executing vector quantization, a pattern is discriminated on the basis of information in a block extracted from a compression target, and vector quantization is executed using an appropriate code book prepared for each pattern. Thus, a greatly versatile system for data compression/decompression, which can obtain a more natural reconstructed image according to the human visual characteristic when, e.g., an image is compressed, and the image is reconstructed using a selected code vector, can be implemented.

In addition, for a solid pattern, similarity is calculated using only pieces of information at the four corners in a block, and simultaneously, the direction of change in the block is detected, and a code vector is selected on the basis of the result. Hence, a greatly versatile system for data compression/decompression, which can properly prevent disadvantage that an unnatural code vector whose data value changes in the block in a direction opposite to that in the entire image is selected and obtain a reconstructed image with a higher quality, can be implemented.

## Claims

1.    A method of making a code book used in vector quantization, said code book comprising a set of code vectors each of which is a data string including at least one unit of data, characterized in that:

a data string of a code vector is made with reference to one or more units of data in the data string constituting the code vector, by giving, to the remaining units of data in the data string, values which vary from the reference data value in order by a predetermined increment.

2.    A method of making a code book used in vector quantization, said code book comprising a set of code vectors each of which is a data string including at least one unit of data, characterized in that:

a data string of a code vector is made by the manner that the data string constituting the code vector is classified into data groups, the total range of the possible values of the respective units of data in the data string is divided by the number of classified data groups, and an arbitrary value in the divided range corresponding to the data group is selectively assigned as each data value in each data group.

3.    A method of making a code book used in vector quantization, said code book comprising a set of code vectors each of which is a data string including at least one unit of data, characterized in that:

a data string of a code vector is made by the manner that the occupation rate of the maximum or minimum value of the possible values of the respective units of data in the data string constituting the code vector is set, the maximum or minimum value is assigned to arbitrary units of data constituting the data string in accordance with the set rate, and the minimum or maximum value is assigned to the other units of data than the units of data to which the maximum or minimum value is assigned.

4.    A method of making a code book used in vector quantization according to claim 3, characterized in that an intermediate value is assigned to predetermined units of data in accordance with the arrangement state of the units of data to which the minimum value is assigned.

5.    A method of making a code book used in vector quantization, said code book comprising a set of code vectors each of which is a data string including at least one unit of data, characterized in that:

said method includes at least two of:
a first making method in which a data string of a code vector is made with reference to one or more units of data in the data string constituting the code vector, by giving, to the remaining units of data in the data string, values which vary from the reference data value in order by a predetermined increment;
a second making method in which a data string of a code vector is made by the manner that the data string constituting the code vector is classified into data groups, the total range of the possible values of the respective units of data in the data string is divided by the number of classified data groups, and an arbitrary value in the divided range corresponding to the data group is selectively assigned as each data value in each data group; and
a third making method in which a data string of a code vector is made by the manner that the occupation rate of the maximum or minimum value of the possible values of the respective units of data in the data string constituting the code vector is set, the maximum or minimum value is assigned to arbitrary units of data constituting the data string in accordance with the set rate, the minimum or maximum value is assigned to the other units of data than the units of data to which the maximum or minimum value is assigned, and an intermediate value is assigned to predetermined units of data in accordance with the arrangement state of the units of data to which the minimum value is assigned; and
code books made by at least two of the first to third making methods are combined to make one code book.

6.    An apparatus for making a code book used in vector quantization, said code book comprising a set of code vectors each of which is a data string including at least one unit of data, characterized by comprising:

> reference value setting means for setting a reference data value to one or more arbitrary units of data in a data string constituting a code vector;
> increment setting means for setting an increment with respect to the reference data value; and
> code vector making means for making the data string of the code vector as a set of data values obtained by sequentially changing the set reference data value by the set increment.

7. An apparatus for making a code book used in vector quantization, said code book comprising a set of code vectors each of which is a data string including at least one unit of data, characterized by comprising:

> data classifying means for classifying a data string constituting a code vector into data groups;
> range dividing means for dividing the total range of the possible values of the respective units of data in the data string by the number of classified data groups; and
> code vector making means for making the data string of the code vector by selectively assigning, as each data value in each classified data group, an arbitrary value in the divided range corresponding to the data group.

8. An apparatus for making a code book used in vector quantization, said code book comprising a set of code vectors each of which is a data string including at least one unit of data, characterized by comprising:

> rate setting means for, in a data string constituting a code vector, setting the occupation rate of the maximum or minimum value of the possible values of the respective units of data in the data string; and
> code vector making means for making the data string of the code vector by assigning the maximum or minimum value to arbitrary units of data constituting the data string in accordance with the set rate and assigning the minimum or maximum value to the other units of data than the units of data to which the maximum or minimum value is assigned.

9. An apparatus for making a code book used in vector quantization according to claim 8, characterized in that said code vector making means assigns an intermediate value to predetermined units of data in accordance with the arrangement state of the units of data to which the minimum value is assigned.

10. An apparatus for making a code book used in vector quantization, characterized by comprising means for making one code book by combining code books made by the code vector making means according to any two of claims 6 to 8.

11. A computer-readable recording medium which stores a program of a procedure of making a code book used in vector quantization, said code book comprising a set of code vectors each of which is a data string including at least one unit of data, characterized in that

> said recording medium records a program for causing a computer to execute a procedure of, with reference to one or more units of data in a data string constituting a code vector, making the data string of the code vector by giving, to the remaining units of data in the data string, values which vary from the reference data value in order by a predetermined increment.

12. A computer-readable recording medium which stores a program of a procedure of making a code book used in vector quantization, said code book comprising a set of code vectors each of which is a data string including at least one unit of data, characterized in that

> said recording medium records a program for causing a computer to execute a procedure of making a data string of a code vector by classifying the data string constituting the code vector into data groups, dividing the total range of the possible values of the respective units of data in the data string by the number of classified data groups, and selectively assigning, as each data value in each data group, an arbitrary value in the divided range corresponding to the data group.

13. A computer-readable recording medium which stores a program of a procedure of making a code book used in vector quantization, said code book comprising a set of code vectors each of which is a data string including at least one unit of data, characterized in that

said recording medium records a program for causing a computer to execute a procedure of making a data string of a code vector by, in the data string constituting the code vector, setting the occupation rate of the maximum or minimum value of the possible values of the respective units of data in the data string, assigning the maximum or minimum value to arbitrary units of data constituting the data string in accordance with the set rate, and assigning the minimum or maximum value to the other units of data than the units of data to which the maximum or minimum value is assigned.

14. A computer-readable recording medium according to claim 13, characterized in that said recording medium records a program for causing the computer to execute a procedure of assigning an intermediate value to predetermined units of data in accordance with the arrangement state of the units of data to which the minimum value is assigned.

15. A computer-readable recording medium which records a code book used in vector quantization, said code book comprising a set of code vectors each of which is a data string including at least one unit of data, and having a data structure in which, with reference to one or more units of data, one code vector is constituted by a set of data values which vary from the reference data value in order by a predetermined increment.

16. A computer-readable recording medium which records a code book used in vector quantization, said code book comprising a set of code vectors each of which is a data string including at least one unit of data, and having a data structure in which one code vector is constituted by classifying a data string constituting a code vector into data groups, dividing the total range of the possible values of the respective units of data in the data string by the number of classified data groups, and selectively assigning, as each data value in each data group, an arbitrary value in the divided range corresponding to the data group.

17. A computer-readable recording medium which records a code book used in vector quantization, said code book comprising a set of code vectors each of which is a data string including at least one unit of data, and having a data structure in which one code vector is constituted by, in a data string constituting a code vector, setting the occupation rate of the maximum or minimum value of the possible values of the respective units of data in the data string, assigning the maximum or minimum value to arbitrary units of data constituting the data string in accordance with the set rate, assigning the minimum or maximum value to the other units of data than the units of data to which the maximum or minimum value is assigned, and assigning an intermediate value to predetermined units of data in accordance with the arrangement state of the units of data to which the minimum value is assigned.

18. An apparatus for making a code book used in vector quantization, said code book comprising a set of vectors each of which is a data string including at least one unit of data, characterized by comprising:

solid pattern generating means for generating at least one type of solid pattern code whose data value gradually varies in a block constituting the vector; and
edge pattern generating means for generating at least one type of edge pattern code whose data value abruptly varies in the block.

19. An apparatus for making a code book used in vector quantization according to claim 18, characterized by comprising storage means for storing the pattern codes generated by said solid pattern generating means and said edge pattern generating means, and

code calculating means for, in executing the vector quantization, performing arithmetic operation for the pattern codes stored in said storage means to generate pattern codes different from the pattern codes.

20. An apparatus for making a code book used in vector quantization according to claim 18 or 19, characterized in that said solid pattern generating means generates a pattern code whose data value gradually varies from an arbitrary side and an arbitrary corner in the block to the opposite side and corner.

21. An apparatus for making a code book used in vector quantization according to any one of claims 18 to 20, characterized in that said solid pattern generating means generates a pattern code in which all data values in the block are constituted by values smaller or larger than an intermediate value of a possible range.

22. An apparatus for making a code book used in vector quantization according to any one of claims 18 to 21, characterized in that said solid pattern generating means generates pattern codes for which degrees of gradual changes are the same, and data values themselves are different.

23. An apparatus for making a code book used in vector quantization according to claim 18 or 19, characterized in that said edge pattern generating means comprises

pattern input means for inputting a reference pattern, and
quantizing means for expressing the input reference pattern only by a predetermined data value group.

24. An apparatus for making a code book used in vector quantization according to claim 18, 19, or 23, characterized in that said edge pattern generating means generates pattern codes for which the differences between data values in the block are the same, and data values themselves are different.

25. An apparatus for making a code book used in vector quantization according to claim 24, characterized in that said edge pattern generating means generates, in addition to the pattern codes for which the differences between data values in the block are the same, pattern codes for which difference ratios are the same, and the data values themselves are different.

26. An apparatus for making a code book used in vector quantization according to claim 19, characterized in that said code calculating means performs at least one of arithmetic operations of block rotation processing and data value inversion processing for each pattern code stored in said storage means.

27. A method of making a code book used in vector quantization, said code book comprising a set of vectors each of which is a data string including at least one unit of data, characterized in that:

at least one type of solid pattern code whose data value gradually varies in a block constituting a vector and at least one type of edge pattern code whose data value abruptly varies in the block, are generated as basic patterns and stored in storage means; and
in executing the vector quantization, pattern codes different from the basic patterns are generated by performing arithmetic operation for the pattern codes stored in the storage means.

28. A method of making a code book used in vector quantization according to claim 27, characterized in that, before execution of the vector quantization, a solid pattern code whose data value gradually varies from an arbitrary side in the block to the opposite side and a solid pattern code whose data value gradually varies from an arbitrary corner in the block to the opposite corner are generated as the basic patterns and stored in the storage means.

29. A method of making a code book used in vector quantization according to claim 27, characterized in that that, before execution of the vector quantization, the edge pattern code is generated by inputting a reference pattern and at least executing quantization processing of expressing the input reference pattern only by a predetermined data value, and stored in the storage means as the basic pattern.

30. A method of making a code book used in vector quantization according to claim 27, characterized in that, in executing the vector quantization, at least one of arithmetic operations of block rotation processing and data value inversion processing is performed for each pattern code stored in the storage means.

31. A vector quantizing device which forms, as a vector, a block from a data string including at least one unit of data, searches for a code vector similar to the vector extracted from a compression target from a code book prepared in advance, and outputs a code corresponding to the code vector, characterized by comprising:

solid pattern generating means for generating at least one type of solid pattern code whose data value gradually varies in the block;
edge pattern generating means for generating at least one type of edge pattern code whose data value abruptly varies in the block;
storage means for storing the pattern codes generated by said solid pattern generating means and said edge pattern generating means;
code calculating means for, in executing the vector quantization, performing arithmetic operation for the pattern codes stored in said storage means to generate pattern codes different from the pattern codes; and
vector quantizing means for executing the vector quantization using the pattern codes read out from said storage means and the pattern codes generated by said code calculating means.

**32.** A method of making a code book used in vector guantization, said code book comprising a set of vectors each of which is a data string including at least one unit of data, characterized in that:

at least one type of solid pattern code is generated in advance as a basic pattern and stored in storage means; and
in executing the vector quantization, a pattern code different from the basic pattern is generated by performing arithmetic operation for the at least one type of pattern code which is stored in the storage means.

**33.** A method of making a code book used in vector quantization according to claim 32, characterized in that the arithmetic operation is at least one of rotation processing and data value inversion processing.

**34.** A computer-readable recording medium characterized in that said recording medium records a program for causing a computer to execute a processing procedure of the code book making method according to claim 32 or 33.

**35.** A vector quantizing device which forms, as a vector, a block from a data string including at least one unit of data, searches for a code vector similar to the vector extracted from a compression target from a code book prepared in advance, and outputs a code corresponding to the code vector, characterized by comprising:

storage means for storing the code book;
calculating means for, in executing the vector quantization, performing arithmetic operation for codes stored in said storage means to generate codes different from the stored codes; and
vector quantizing means for executing the vector quantization using the codes read out from said storage means and the codes generated by said calculating means.

**36.** A vector quantizing device used in vector quantization according to claim 35, characterized in that arithmetic operation by said calculating means is at least one of rotation processing and data value inversion processing.

**37.** A computer-readable recording medium which records a vector quantization program for forming, as a vector, a block from a data string including at least one unit of data, searching for a code vector similar to the vector extracted from a compression target from a code book prepared in advance, and outputting a code corresponding to the code vector, characterized in that said computer-readable recording medium records a program for causing a computer to execute:

the calculating step of, in executing the vector quantization, performing arithmetic operation for codes stored in storage means to generate codes different from the stored codes; and
the vector quantizing step of executing the vector quantization using the codes read out from the storage means and the codes generated in the calculating step.

**38.** A computer-readable recording medium according to claim 37, characterized in that, as arithmetic operation in the calculating step, at least one of rotation processing and data value inversion processing is performed.

**39.** A device for data compression, which forms, as a vector, a block from a data string including at least one unit of data, searches for a code vector similar to the vector extracted from a compression target from a code book prepared in advance, and outputs a code corresponding to the code vector, characterized by comprising:

code book storage means for storing a code book prepared for every different type of pattern;
discriminating means for discriminating a type of pattern of data of the block on the basis of information in the block of the compression target; and
vector quantizing means for executing vector quantization processing using the code books prepared for the respective patterns in accordance with a discrimination result by said discriminating means.

**40.** A device for data compression according to claim 39, characterized in that said discriminating means discriminates, on the basis of data values of elements in the block of the compression target, between a first pattern whose data value gradually varies in a certain direction in the block and a second pattern whose data value abruptly varies in the block.

**41.** A device for data compression according to claim 40, characterized in that said discriminating means discriminates the block as the first pattern when the difference between the maximum and minimum values of the elements in the block is smaller than a predetermined threshold value, and discriminates the block as the second pattern when the difference between the maximum and minimum values in the block is larger than the predetermined threshold value.

42. A device for data compression according to any one of claims 39 to 41, characterized in that said vector quantizing means obtains similarity for the blocks of different types of patterns by different processes.

43. A device for data compression according to claim 42, characterized in that, for the first pattern in which the data value of each element in the block of the compression target gradually varies, said vector quantizing means obtains the similarity using only data values of elements at the four corners in a rectangular block.

44. A device for data compression according to claim 43, characterized in that said vector quantizing means detects a direction of data value change in the block from the data values at the four corners in the block and searches for the similar code vector also in consideration of the direction.

45. A device for data compression according to claim 43 or 44, characterized in that each code vector constituting the code book for the first pattern has only pieces of information on the elements at the four corners in the block.

46. A device for data decompression which uses a data string including at least one unit of data as a vector, searches for a code vector corresponding to a compression code from a code book including at least one code vector, and assigns the code vector to a corresponding block position to reconstruct original data, characterized by comprising:

code book storage means for storing a code book prepared for every different type of pattern; and
decoding means for, on the basis of compression codes generated on the compressing side for the respective patterns of different types, searching for code vectors corresponding to the compression codes, from the code books prepared for the respective patterns.

47. A device for data decompression according to claim 46, characterized in that the different types of patterns include a first pattern in which the data value of each element in the block of the compression target gradually varies in a certain direction in the block and a second pattern in which the data value abruptly varies in the block.

48. A device for data decompression according to claim 47, characterized in that each code vector constituting the code book for the first pattern has only pieces of information on the elements at the four corners in the rectangular block.

49. A device for data decompression according to claim 48, characterized by further comprising calculating means for calculating, by arithmetic operation, pieces of information on the other elements on the basis of pieces of information on the elements at the four corners in the block.

50. A method for data compression in which a block is formed, as a vector, from a data string including at least one unit of data, a code vector similar to the vector extracted from a compression target is searched from a code book prepared in advance, and a code corresponding to the code vector is output, characterized in that:

a type of pattern of data in the block of the compression target is discriminated on the basis of information in the block and vector quantization processing is executed using code books prepared for the respective patterns in accordance with a discrimination result.

51. A method for data decompression according to claim 50, characterized in that the different types of patterns include a first pattern in which the data value of each element in the block of the compression target gradually varies in a certain direction in the block and a second pattern in which the data value abruptly varies in the block.

52. A method for data compression according to claim 51, characterized in that, in executing the vector quantization processing, for the blocks of the patterns of different types, similarities of vectors are obtained by different processes, and, for the first pattern, the similarity is obtained using only data values of elements at the four corners in a rectangular block.

53. A method for data compression according to claim 52, characterized in that a direction of data value change is detected in the block from the data values at the four corners in the block and the similar code vector is searched also in consideration of the direction.

54. A method for data decompression in which a data string including at least one unit of data is used as a vector, a code vector corresponding to a compression code is searched from a code book including at least one code vector, and the code vector is assigned to a corresponding block position to reconstruct original data, characterized in that:

on the basis of compression codes generated on the compressing side for the respective different types of patterns, code vectors corresponding to the compression codes are searched from code books prepared for the respective patterns.

55. A method for data decompression according to claim 54, characterized in that the different types of patterns include a first pattern in which the data value of each element in the block of the compression target gradually varies in a certain direction in the block and a second pattern in which the data value abruptly varies in the block.

56. A method for data decompression according to claim 55, characterized in that each code vector constituting the code book for the first pattern has only pieces of information on the elements at the four corners in a rectangular block, and, in searching for the code vector corresponding to the compression code and assigning the code vector to the corresponding block position, by arithmetic operation, pieces of information on the other elements are calculated on the basis of pieces of information on the elements at the four corners in the block.

57. A system for data compression/decompression including a device for data compression which forms, as a vector, a block from a data string including at least one unit of data, searches for a code vector similar to the vector extracted from a compression target from a code book prepared in advance, and outputs a code corresponding to the code vector, and a device for data decompression which searches for a code vector corresponding to the code from the code book and assigns the code vector to a corresponding block position to reconstruct original data, characterized in that

said device for data compression comprises first code book storage means for storing a code book prepared for every different type of pattern,
discriminating means for discriminating a type of pattern of data of the block on the basis of information in the block of the compression target, and
vector quantizing means for executing vector quantization processing using the code books prepared for the respective patterns in accordance with a discrimination result by said discriminating means; and
said device for data decompression comprises second code book storage means for storing a code book prepared for every different type of pattern, and
decoding means for, on the basis of compression codes generated on the compressing side for the respective patterns of different types, searching for code vectors corresponding to the compression codes from the code books prepared for the respective patterns.

58. A system for data compression/decompression according to claim 57, characterized in that each of said first and second code book storage means stores the code books of the different types of patterns in a single storage device.

59. A system for data compression/decompression according to claim 57, characterized in that each of said first and second code book storage means separately stores the code books of the different types of patterns in storage devices, and

information for identifying a pattern is supplied to said device for data decompression together with the code generated by said device for data compression.

60. A computer-readable recording medium characterized in that said recording medium stores a program for causing a computer to function as each means according to claim 39.

61. A computer-readable recording medium characterized in that said recording medium stores a program for causing a computer to realize the function according to any one of claims 40 to 44.

62. A computer-readable recording medium characterized in that said recording medium stores a program for causing a computer to function as each means according to claim 46 or 49.

**63.** A computer-readable recording medium characterized in that said recording medium stores a program for causing a computer to execute a processing procedure of the method for data compression according to any one of claims 50 to 53.

**64.** A computer-readable recording medium characterized in that said recording medium stores a program for causing a computer to execute a processing procedure of the method for data decompression according to any one of claims 54 to 56.

# F I G. 1

```
        1                              3
┌──────────────────┐        ┌──────────────────┐
│ START POINT SETTING│        │ INCREMENT SETTING│
│     SECTION       │        │     SECTION      │
└──────────────────┘        └──────────────────┘
         │                          │
         │                          │        4
         ▼        2                 ▼
┌──────────────────┐        ┌──────────────────┐
│    GROUPING      │        │      START       │
│    SECTION       │        │ POINT LUMINANCE  │
└──────────────────┘        │ VALUE SETTING    │
         │                  │    SECTION       │
         │                  └──────────────────┘
         │          │                │
         │          │                │        5
         ▼          ▼                ▼
┌────────────────────────────────────────────┐
│         CODE BOOK MAKING                    │
│             SECTION                         │
└────────────────────────────────────────────┘
                    │
                    │        6
                    ▼
          ┌──────────────────┐
          │    CODE BOOK      │
          │   DATA MEMORY     │
          └──────────────────┘
```

# F I G. 2

START

DIVIDE 4×4 BLOCKS
INTO SEVERAL GROUPS
(GROUP COUNT N) ~S1

GIVE INCREMENT (STEP) OF LUMINANCE
BETWEEN ADJACENT GROUPS,
i=0 ~S2

EQUALLY DIVIDE RANGE OF
0 TO (225−(N−1)×STEP)
AND GIVE LUMINANCE VALUE AT
START POINT TO GROUP SERVING
AS START POINT ~S3

SHIFT TO ADJACENT GROUP,
i=i+1 ~S4

S5
i<N? — NO

YES

GIVE LUMINANCE VALUE (LUMINANCE
VALUE OF GROUP AT START POINT
+i×STEP) TO CURRENT GROUP,
i=i+1 ~S6

STORE GENERATED
CODE VECTOR
IN MEMORY ~S7

END

# F I G. 3

A B C D

①  ②  ⑤  ⑥

③  ④  ⑦  ⑧

(a)

K  K+40

K+20  K+60

(b)

# F I G. 4

EP 1 087 533 A1

# F I G. 5

```
                                    11
    ┌──────────────────────┐
    │  START POINT SETTING │
    │       SECTION        │
    └──────────────────────┘
                │
                ▼
                                    12                          13
    ┌──────────────────────┐           ┌──────────────────────┐
    │      GROUPING        │           │   DYNAMIC RANGE      │
    │      SECTION         │           │     DIVIDING         │
    └──────────────────────┘           │     SECTION          │
                │                       └──────────────────────┘
                │                                   │
                ▼                                   ▼
                                                                    14
    ┌──────────────────────────────────────────────────────────┐
    │             CODE BOOK MAKING                               │
    │                SECTION                                     │
    └──────────────────────────────────────────────────────────┘
                            │
                            ▼
                                            15
                ┌──────────────────────┐
                │                      │
                │    CODE BOOK         │
                │   DATA MEMORY        │
                │                      │
                └──────────────────────┘
```

# F I G. 6

START

DIVIDE 4×4 BLOCKS
INTO SEVERAL GROUPS ～S11
(GROUP COUNT N)

DIVIDE DYNAMIC RANGE OF
LUMINANCE VALUES INTO
N PARTS $(S_0, S_1, \cdots, S_{N-1})$, ～S12
$i=0$

GIVE LUMINANCE VALUE
BELONGING TO $S_0$ TO GROUP ～S13
SERVING AS START POINT

SHIFT TO ADJACENT GROUP, ～S14
$i=i+1$

S15
$i<N?$  NO

YES

S16
GIVE LUMINANCE VALUE
BELONGING TO $S_i$ TO
CURRENT GROUP,
$i=i+1$

S17
STORE GENERATED
CODE VECTOR
IN MEMORY

END

# F I G. 7

(a)

```
0      63 95     159 191    255
|       |  |      |   |       |
   A      B    C     D     E
```

(b)

# F I G. 8

```
┌─────────────────────┐
│  MINIMUM  LUMINANCE  │
│   RATIO  SETTING     │~21
│     SECTION          │
└─────────────────────┘
          │
          ▼
┌─────────────────────┐
│   MAXIMUM/MINIMUM    │~22
│ LUMINANCE VALUE SETTING │
│     SECTION          │
└─────────────────────┘
          │
          ▼
┌─────────────────────┐
│   LUMINANCE VALUE    │
│     CONVERSION       │~23
│     SECTION          │
└─────────────────────┘
          │
          ▼
┌─────────────────────┐
│                      │
│     CODE  BOOK       │~24
│   DATA MEMORY        │
│                      │
└─────────────────────┘
```

# F I G. 9

START

DETERMINE RATIO OF
BLACK IN
4×4 BLOCK ~S21

GIVE BLACE IN ACCORDANCE
WITH RATIO AND GIVE WHITE ~S22
TO OTHER PORTIONS

S23
BLACK DOTS
LINEARLY OCCUPY
4×4 BLOCK? NO

YES

CHAHGE WHITE DOT ADJACENT
TO BLACK DOT TO HALFTONE ~S24

STORE GENERATED CODE ~S25
VECTOR IN MEMORY

END

# F I G. 10

1 × 1
1 × 2
1 × 3
1 × 4
2 × 2
2 × 3
2 × 4

(1×2)   (1×1)

(a)

(b)

(c)

(d)

F I G. 11

EP 1 087 533 A1

# F I G. 12

# F I G. 13

```
        121
    ┌──────────┐
    │ ORIGINAL │
    │  IMAGE   │
    │  INPUT   │
    │ SECTION  │
    └────┬─────┘
         │           123                122                110
         ↓      ┌──────────────┐  ┌──────────────┐  ┌──────────────┐
    ┌──────────┐│  SIMILARITY  │  │    CODE      │  │    CODE      │
    │SIMILARITY││ ARITHMETIC   │←─│    BOOK      │←─│    BOOK      │
    │ARITHMETIC││ OPERATION    │  │ ARITHMETIC   │  │    DATA      │
    │OPERATION ││  SECTION     │  │ OPERATION    │  │   MEMORY     │
    │ SECTION  │└──────────────┘  │  SECTION     │  └──────────────┘
    └────┬─────┘                  └──────────────┘
         │           124
         ↓
    ┌──────────┐
    │   CODE   │
    │DETERMINING│
    │ SECTION  │
    └────┬─────┘
         │
         ↓
       CODE
```

F I G. 14

# F I G. 15

# F I G. 16

```
            ┌─────────────┐
            │    START    │
            └─────────────┘
                   │
                   ▼
    ┌───────────────────────────┐
    │  DIVIDE 4×4 BLOCKS INTO    │ ∼S101
    │      SEVERAL GROUPS        │
    └───────────────────────────┘
                   │
                   ▼
    ┌───────────────────────────┐
    │  DETERMINE INCREMENT (h) OF │
    │ LUMINANCE VALUE AT END POINT│ ∼S102
    │    VIEWED FROM START POINT  │
    └───────────────────────────┘
                   │
                   ▼
    ┌───────────────────────────┐
    │     EQUALLY DIVIDE RANGE OF │
    │ 0 TO (INTERMEDIATE VALUE−h) │
    │   AND GIVE LUMINANCE VALUE  │ ∼S103
    │        AT START POINT       │
    └───────────────────────────┘
                   │
                   ▼
    ┌───────────────────────────┐
    │ LINEARLY INTERPOLATE GROUPS OTHER │
    │  THAN THOSE CORRESPONDING TO      │ ∼S104
    │   START POINT AND END POINT       │
    └───────────────────────────┘
                   │
                   ▼
    ┌───────────────────────────┐
    │  STORE GENERATED CODE BOOK │ ∼S105
    │         IN MEMORY          │
    └───────────────────────────┘
                   │
                   ▼
            ┌─────────────┐
            │     END     │
            └─────────────┘
```

# F I G. 17

```
            ┌──────────┐
            │  START   │
            └──────────┘
                 │
                 ▼
    ┌─────────────────────────────┐
    │   CONSTITUTE LUMINANCE IN   │
    │   BLOCK WITH REFERENCE      │
    │   TO ORIGINAL IMAGE IN      │~S111
    │ WHICH  DIFFERENCE BETWEEN   │
    │  BLACK AND WHITE IS CLEAR   │
    └─────────────────────────────┘
                 │
                 ▼
 ┌──────────────────────────────────┐
 │ QUANTIZE LUMINANCE IN ORIGINAL IMAGE │~S112
 └──────────────────────────────────┘
                 │
                 ▼
 ┌──────────────────────────────────┐
 │  EXPRESS BLOCK BY ONLY INCREMENT  │~S113
 └──────────────────────────────────┘
                 │
                 ▼
 ┌──────────────────────────────────┐
 │ DECREASE ENTIRE LUMINANCE IN BLOCK │~S114
 │  TO GIVE VARIATIONS TO PATTERN     │
 └──────────────────────────────────┘
                 │
                 ▼
    ┌─────────────────────────────┐
    │   EQUALLY DIVIDE RANGE OF    │
    │ 0 TO (MAXIMUM VALUE −h')     │~S115
    │  AND GIVE LUMINANCE VALUE    │
    │      AT START POINT          │
    └─────────────────────────────┘
                 │
                 ▼
    ┌─────────────────────────────┐
    │  MAKE CODE BOOK ON THE BASIS OF │~S116
    │ LUMINANCE VALUE AT START POINT  │
    └─────────────────────────────┘
                 │
                 ▼
 ┌──────────────────────────────────┐
 │ STORE GENERATED CODE BOOK IN MEMORY │~S117
 └──────────────────────────────────┘
                 │
                 ▼
            ┌──────────┐
            │   END    │
            └──────────┘
```

# F I G. 18

```
         ( START )
             |
             v
┌─────────────────────────┐
│  INPUT  ORIGINAL  IMAGE  │~S121
└─────────────────────────┘
             |
             v
┌─────────────────────────┐
│  READ  CODE  BOOK  DATA  │~S122
└─────────────────────────┘
             |
             v
┌───────────────────────────────┐
│ PERFORM 90° ROTATION FOUR TIMES │~S123
└───────────────────────────────┘
             |
             v
┌─────────────────────────┐
│ INVERT  WHITE  AND  BLACK │~S124
└─────────────────────────┘
             |
             v
┌───────────────────────────────┐
│ PERFORM VQ ARITHMETIC OPERATION │~S125
└───────────────────────────────┘
             |
             v
┌─────────────┐
│ OUTPUT CODE │~S126
└─────────────┘
             |
             v
         (  END  )
```

# F I G. 19

SEARCH THRESHOLD
VALUE INPUT SECTION  ~203

IMAGE INPUT
SECTION  ~201

PIXEL ARITHMETIC
OPERATION SECTION  ~202

CODE BOOK STORAGE SECTION  ~205

SOLID PATTERN CODE BOOK  ~205a

EDGE PATTERN CODE BOOK  ~205a

CODE-BOOK-SCHEME
COMPRESSING SECTION  ~204

CODE NUMBER
OUTPUT SECTION  ~206

CODE NUMBER
INPUT SECTION  ~207

CODE BOOK STORAGE SECTION  ~209

SOLID PATTERN CODE BOOK  ~209a

EDGE PATTERN CODE BOOK  ~209b

CODE-BOOK-SCHEME
DECOMPRESSING SECTION  ~208

IMAGE DISPLAY OR
STORAGE DEVICE  ~210

# F I G. 20

ORIGINAL
IMAGE

LOW-FREQUENCY
PATTERN

HIGH-FREQUENCY
PATTERN

LOW-FREQUENCY
CODE BOOK

LOW-FREQUENCY
VQ

VQ

HIGH-FREQUENCY
VQ

HIGH-FREQUENCY
CODE BOOK

COMPRESSED
DATA

EP 1 087 533 A1

# F I G. 21

(a)

(b)

# F I G. 22

```
                    START

              CLEAR BLOCK
              COUNTER            S201

              GIVE SEARCH
           THRESHOLD VALUE (Tн)   S202

           INPUT IMAGE BLOCK      S203

         (MAXIMUM VALUE
          - MINIMUM VALUE)    No
         OF LUMINANCE VALUE
          IN BLOCK > Tн?      S204
              Yes

     SEARCH FROM           SEARCH FROM
   EDGE SECTION IN       SOLID SECTION IN
   CODE BOOK (VQ)        CODE BOOK (VQ)
              S205                  S206

            ENCODING
              S207

        OUTPUT CODE NUMBER      INCREMENT BLOCK
              S208              COUNTER BY ONE
                                      S210

           ALL BLOCK       No
           ENDED?
              S209
              Yes

              END
```

# F I G. 23

```
                    ( START )
                        │
                        ▼
            ┌───────────────────────┐
            │     CLEAR  BLOCK       │
            │       COUNTER          │
            └───────────────────────┘  ⌇S211
                        │
                        ▼
            ┌───────────────────────┐
            │   INPUT  CODE  NUMBER  │
            └───────────────────────┘
                        │                  ⌇S212
                        ▼
            ┌───────────────────────┐
            │  SEARCH  FOR  PATTERN  │
            │  CORRESPONDING  TO     │
            │  CODE  NUMBER  FORM    │
            │     BOOK  (VQ)         │
            └───────────────────────┘
                        │                 ⌇S213
                        ▼                           ┌──────────────────────┐
            ┌───────────────────────┐               │  INCREMENT  BLOCK     │
            │ DISPLYA OR STORE IMAGE │               │  COUNTER  BY  ONE     │
            └───────────────────────┘               └──────────────────────┘
                        │         ⌇S214                         ⌇S216
                        ▼
                   ╱ALL  BLOCK╲   No
                  ⟨  ENDED?    ⟩───────────────────────┘
                   ╲          ╱
                        │  ⌇S215
                      Yes│
                        ▼
                    ( END )
```

# F I G. 24

SEARCH THRESHOLD VALUE INPUT SECTION ⌇203

IMAGE INPUT SECTION ⌇201

PIXEL ARITHMETIC OPERATION SECTION ⌇202

CODE-BOOK-SCHEME COMPRESSING SECTION ⌇204

SOLID PATTERN CODE BOOK STORAGE SECTION ⌇211

EDGE PATTERN CODE BOOK STORAGE SECTION ⌇212

CODE NUMBER OUTPUT SECTION ⌇206

CODE NUMBER INPUT SECTION ⌇207

CODE-BOOK-SCHEME DECOMPRESSING SECTION ⌇208

SOLID PATTERN CODE BOOK STORAGE SECTION ⌇213

EDGE PATTERN CODE BOOK STORAGE SECTION ⌇214

IMAGE DISPLAY OR STORAGE DEVICE ⌇210

EP 1 087 533 A1

# F I G. 25

```
        ( START )
            │
            ▼
   ┌──────────────────┐
   │  CLEAR  BLOCK    │
   │    COUNTER       │ ── S201
   └──────────────────┘
            │
            ▼
   ┌──────────────────┐
   │  GIVE  SEARCH    │
   │ THRESHOLD VALUE  │ ── S202
   │      (T_H)       │
   └──────────────────┘
            │
            ▼
   ┌──────────────────┐
   │ INPUT IMAGE BLOCK│ ── S203
   └──────────────────┘
            │
            ▼
        ╱(MAXIMUM VALUE╲
       ╱  – MINIMUM VALUE)╲   No
      ◇ OF LUMINANCE VALUE ◇ ───────┐
       ╲  IN BLOCK > T_H? ╱         │
        ╲      S204      ╱          │
            │ Yes                   │
            ▼                       ▼
   ┌──────────────────┐   ┌──────────────────┐
   │  SEARCH FROM     │   │  SEARCH FROM     │
   │ EDGE PATTERN CODE│   │ SOLID PATTERN CODE│
   │ BOOK (VQ),Flag=1 │   │ BOOK (VQ),Flag=1 │
   └──────────────────┘   └──────────────────┘
       S221                   S222
            │                       │
            ▼                       │
   ┌──────────────────┐             │
   │    ENCODING      │◄────────────┘
   └──────────────────┘ ── S207
            │
            ▼
   ┌──────────────────┐   ┌──────────────────┐
   │OUTPUT FLAG VALUE │   │ INCREMENT BLOCK  │
   │ AND CODE NUMBER  │   │ COUNTER BY ONE   │
   └──────────────────┘   └──────────────────┘
       S223                   S210
            │                       ▲
            ▼                       │
        ╱ ALL BLOCK ╲   No          │
       ◇  ENDED?    ◇───────────────┘
        ╲   S209   ╱
            │ Yes
            ▼
         ( END )
```

# F I G. 26

START

CLEAR BLOCK
COUNTER
↳ S211

INPUT Flag VALUE
AND CODE NUMBER
↳ S224

Flag =1? — No
↙ Yes   S225

SEARCH FOR PATTERN
CORRESPONDING TO
CODE NUMBER FORM
EDGE PATTERN
CODE BOOK (VQ)
↳ S226

SEARCH FOR PATTERN
CORRESPONDING TO
CODE NUMBER FORM
SOLID PATTERN
CODE BOOK (VQ)
↳ S227

DISPLAY OR STORE IMAGE
↳ S214

INCREMENT BLOCK
COUNTER BY ONE
↳ S216

ALL BLOCK
ENDED? — No
↓ Yes   S215

END

# F I G. 27

# F I G. 28

301 — IMAGE INPUT UNIT

302 — COMPRESSING UNIT USING CODE BOOK SCHEME

303 CODE BOOK STORAGE UNIT

CODE NUMBER

# F I G. 29

DIRECTION OF CHANGE
OF ENTIRE LUMINANCE

DIRECTION OF
LUMINANCE CHANCE
IN BLOCK

(a)

(b)

<div align="center">INTERNATIONAL SEARCH REPORT</div>

| International application No. |
|---|
| PCT/JP99/02050 |

**A. CLASSIFICATION OF SUBJECT MATTER**
Int.Cl⁶ H03M7/30, H04N1/41, H04N7/28

According to International Patent Classification (IPC) or to both national classification and IPC

**B. FIELDS SEARCHED**

Minimum documentation searched (classification system followed by classification symbols)
Int.Cl⁶ H03M7/30, H04N1/41-1/419, H04N7/24-7/68

Documentation searched other than minimum documentation to the extent that such documents are included in the fields searched

| | | | |
|---|---|---|---|
| Jitsuyo Shinan Koho | 1926-1996 | Toroku Jitsuyo Shinan Koho | 1994-1999 |
| Kokai Jitsuyo Shinan Koho | 1971-1999 | Jitsuyo Shinan Toroku Koho | 1996-1999 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP, 6-164939, A (Fuji Xerox Co., Ltd.), 10 June, 1994 (10. 06. 94), Column 8, line 37 to column 9, line 27 ; Fig. 4 (Family: none) | 1, 5, 6, 10, 11, 15, 18-31, 40-42, 47, 51, 55, 61 |
| A | | 43, 44, 45, 48, 49, 52, 53, 56 |
| X | JP, 64-82779, A (Canon Inc.), 28 March, 1989 (28. 03. 89), Page 5, lower right column, line 11 to page 6, line 15 ; page 8, upper left column, lines 1 to 12, upper right column, lines 10 to 14 (Family: none) | 2, 7, 12, 16, 32-39, 46, 54, 60, 62, 64 |
| Y | | 1, 4-6, 9-11, 14, 15, 17-31, 40-42, 47, 51, 55, 61 |
| A | | 43, 44, 45, 48, 49, 52, 53, 56 |

| ☒ Further documents are listed in the continuation of Box C. | ☐ See patent family annex. |
|---|---|

| Date of the actual completion of the international search | Date of mailing of the international search report |
|---|---|
| 13 July, 1999 (13. 07. 99) | 27 July, 1999 (27. 07. 99) |

| Name and mailing address of the ISA/ | Authorized officer |
|---|---|
| Japanese Patent Office | |
| Facsimile No. | Telephone No. |

Form PCT/ISA/210 (second sheet) (July 1992)